# EUROPEAN PATENT SPECIFICATION

(11) **EP 2 318 474 B1**
(45) Date of publication and mention of the grant of the patent: **27.05.2015**
(21) Application number: 09777545.6
(22) Date of filing: 30.07.2009
(51) Int. Cl.: C09K 11/06, H01L 51/50

(54) **COMPOUND HAVING ELECTROLUMINESCENT OR ELECTRON TRANSPORT PROPERTIES AND ITS PREPARATION AND USE**
VERBINDUNG MIT ELEKTROLUMINESZENZ- ODER ELEKTRONENTRANSPORTEIGENSCHAFTEN UND DEREN HERSTELLUNG UND VERWENDUNG
COMPOSÉ AYANT DES PROPRIÉTÉS ÉLECTROLUMINESCENTES OU DE TRANSPORT D ÉLECTRONS ET PRÉPARATION ET UTILISATION ASSOCIÉES

(30) Priority: 13.08.2008 GB 0814749
(43) Date of publication of application: 11.05.2011
(73) Proprietor: Merck Patent GmbH, 64293 Darmstadt (DE)
(72) Inventor: KATHIRGAMANATHAN, Poopathy, North Harrow HA2 7NN (GB); SURENDRAKUMAR, Sivagnanasundram, Edgware, Middlesex HA8 6DL (GB)
(86) International application number: PCT/EP2009/005523
(87) International publication number: WO 2010/017896

(56) References cited:
- WO-A1-2006/024831
- WO-A1-2008/078115
- WO-A2-2007/052083
- US-A1- 2004 247 936

## Description

### FIELD OF THE INVENTION

This invention relates to a novel compound, to a method for its preparation and to its use in *inter alia* optical light emitting devices e.g. in an electron transport layer or as a host in an electroluminescent layer in the field of flat panel displays and/or in lighting.

### BACKGROUND TO THE INVENTION

Kulkarni et al., Chem. Mater. 2004, 16, 4556-4573 have reviewed the literature concerning electron transport materials (ETMs) used to enhance the performance of organic light-emitting diodes (OLEDs). In addition to a large number of organic materials, they discuss metal chelates including aluminium quinolate, which they explain remains the most widely studied metal chelate owing to its superior properties such as high EA (∼ -3.0 eV; measured by the present applicants as - 2.9 eV) and IP (∼ -5.95 eV; measured by the present applicants as about - 5.7 eV), good thermal stability (Tg ∼ 172°C) and ready deposition of pinhole-free thin films by vacuum evaporation. Aluminium quinolate remains a preferred material both for use as a host to be doped with various fluorescent materials to provide an electroluminescent layer and for use as an electron transport layer.

Zirconium quinolate has a particularly advantageous combination of properties for use as an electron transport material and which identify it as being a significant improvement on aluminium quinolate for that use. It has high electron mobility. Its melting point (388°C) is lower than that of aluminium quinolate (414°C). Its lowest unoccupied molecular orbital (LUMO) is at - 2.9 eV and its highest occupied molecular orbital (HOMO) is at - 5.6 eV, similar to the values of aluminium quinolate. Furthermore, unexpectedly, it has been found that when incorporated into an electron transport layer it slows loss of luminance of an OLED device at a given current with increase of the time for which the device has been operative (i.e. increases device lifetime), or increases the light output for a given applied voltage, the current efficiency for a given luminance and/or the power efficiency for a given luminance. Embodiments of cells in which the electron transport material is zirconium quinolate can exhibit reduced turn-on voltage and up to four times the lifetime of similar cells in which the electron transport material is aluminium quinolate. It is compatible with aluminium quinolate when aluminium quinolate is used as host in the electroluminescent layer of an OLED, and can therefore be employed by many OLED manufacturers with only small changes to their technology and equipment. It also forms a good electrical and mechanical interface with inorganic electron injection layers e.g. a LiF layer where there is a low likelihood of failure by delamination. As described below, it also gives good results when interfaced with organolithium compounds as electron injection materials e.g. lithium quinolate or a substituted lithium quinolate or lithium Schiff bases. Zirconium quinolate can also be used as a host or as a component of the host material in the electroluminescent layer.

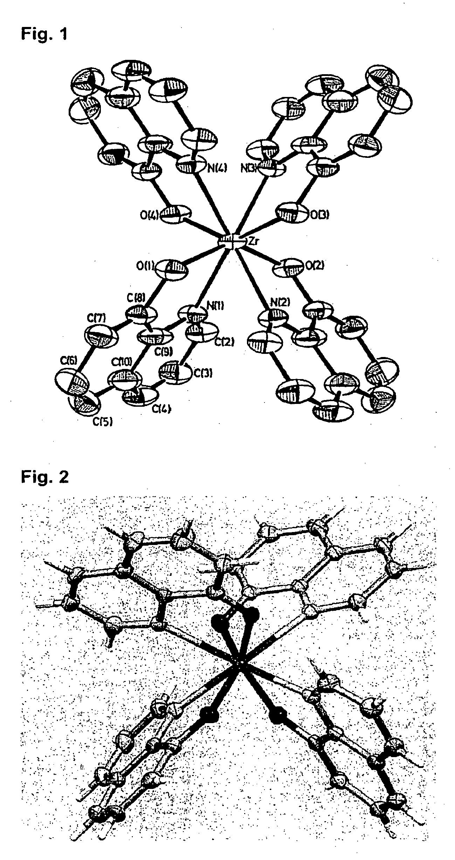

A crystal structure for Zrq₄.[toluene]₃ is reported by Lewis D.F. et al., J. Chem Soc. Chem. Comm., 1974, 1046 and is shown in Fig. 1, the molecules of toluene which form part of the crystal structure being omitted. The authors describe zirconium quinolate having a orthorhombic crystal structure with the space group Fddd and the unit cell parameters a = 14.168 Å, b = 27.720 Å, and c = 21.371 Å.

WO 2006/024831 A1 discloses the synthesis of zirconium 2-methyl quinolate (Zr(q-2Me)₄).

### SUMMARY OF THE INVENTION

We have found that different methods of making zirconium quinolate produce forms having different structures and properties.

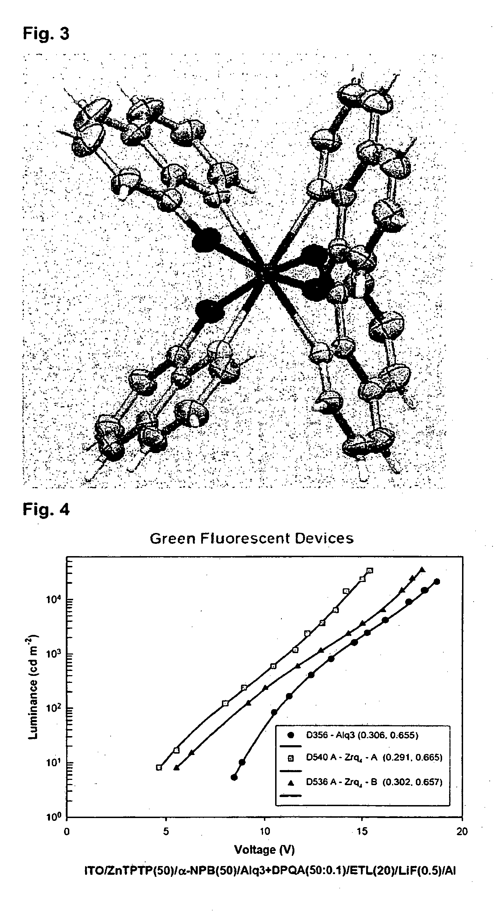

Zirconium quinolate made by a previously disclosed method using zirconium chloride as starting material and ethanol as solvent [referred to as Zrq₄-B or B-form] has an orthorhombic, primitive crystal structure with unit cell dimensions a = 8.24 Å, b = 17.35 Å, c = 19.96 Å, α = β = γ = 90° and a unit cell volume of 2844 Å³. Its structure is shown in Fig. 3.

However, zirconium quinolate made from a zirconium alkoxide e.g. zirconium isopropoxide in a solvent comprising tetrahydrofuran is readily purifiable by sublimation and after purification is substantially pure zirconium quinolate having a monoclinic crystal structure, P21/c space group, unit cell dimensions a = 11.22 Å, b = 14.67 Å, c = 17.21 Å α = 90°, β = 94.816°, γ = 90°, unit cell volume 2822.7 Å³ [referred to as Zrq₄-A or A-form]. Its structure is shown in Fig. 2. The A-form has significantly better sublimation properties (e.g. in embodiments it can sublime without residue) and gives significantly better performance e.g. when used as an electron transport layer in an OLED.

The invention therefore relates to the monoclinic A-form of zirconium quinolate, to its method of production and to use e.g. electron transport layer in devices.

The invention further comprises an optical light emitting diode device having a first electrode, a layer comprising monoclinic zirconium quinolate and a second electrode.

Monoclinic zirconium quinolate may be used as an electron transport material in OLEDs, as an electroluminescent material or as a host material, being dopable as described below. It may also be used in lighting.

Monoclinic zirconium quinolate, when used to provide an electron transport layer may be n-doped e.g. with lithium, potassium, caesium or another low work function metal. It may be used alone or in admixture with another organic small molecule electron transport material either un-doped or n-doped. It may be used with inorganic electron injection layers e.g. LiF or with organic small molecule electron injection layers e.g. as described below under the heading "electron injection materials".

Thus embodiments of the invention may further provide an electroluminescent device having first and second electrodes and between said electrodes an electroluminescent layer which comprises monoclinic zirconium quinolate which may be doped with a fluorescent dopant, a phosphorescent dopant or an ion fluorescent dopant.

### BRIEF DESCRIPTION OF THE DRAWINGS

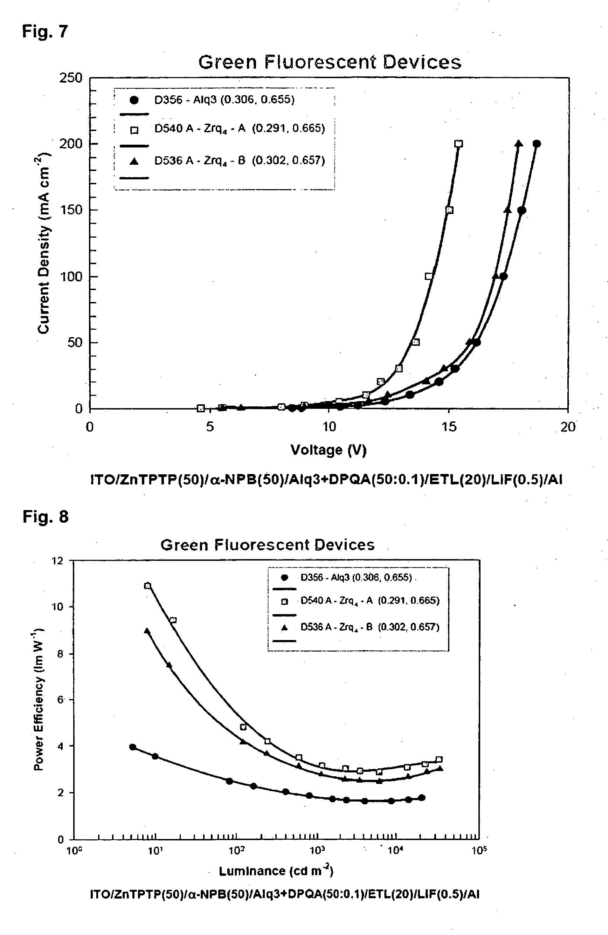

The invention will be further described with reference to the drawings, in which Figs. 1-3 show structures of various forms of zirconium quinolate determined by X-ray crystallography and Figs. 4-8 are performance curves showing how monoclinic zirconium quinolate compares to the orthorhombic form and to aluminium quinolate.

### DESCRIPTION OF PREFERRED EMBODIMENTS

### Crystal structure

The present invention relates to zirconium quinolate having a monoclinic crystal structure, preferably with the space group P21/c.

A particularly preferred embodiment of the present invention is zirconium quinolate having monoclinic crystal structure with space group P21/c, characterized in that the unit cell dimensions are a = 11.2 ± 0.4 Å, b = 14.7 ± 0.4 Å, c = 17.2 ± 0.4 Å, α = 90°, β = 95° ± 1°, γ = 90°, and unit cell volumen V = 2823 ± 5 Å³ and very particularly preferably the cell dimensions are a = 11.22 Å, b = 14.67 Å, c = 17.21 Å, α = 90°, β = 94.816°, γ = 90°, and unit cell volumen V = 2822.7 Å³.

In another preferred embodiement of the present invention the zicronium quinolate having the monoclinic crystal form as described above has a purity of greater than or equal to 80%, preferably greater than or equal to 85%, particularly preferably greater than or equal to 90%, and very particularly preferably greater than or equal to 95%.

The term "substantially pure" is used herein to define a purity of greater than or equal to 95%.

### Preparation of zirconium quinolate

The present invention also relates to a method of making zirconium quinolate in monoclinic form, which comprises reacting zirconium alkoxide with 8-hydroxyquinoline in a solvent comprising tetrahydrofuran, recovering the zirconium quinolate and purifying it by sublimation. Preferably the zirconium alkoxide is zirconium isopropoxide.

### Cell structure

The OLEDs of the invention are useful *inter alia* in flat panel displays and in embodiments comprise an anode and a cathode between which is sandwiched a multiplicity of thin layers including an electroluminescent layer, electron injection and/or transport layer(s), hole injection and/or transport layer(s) and optionally ancillary layers. The layers are in embodiments built up by successive vacuum vapour deposition operations, although it may be convenient to form one or more of the layers e.g. the hole injection and hole transport layers by other methods e.g. spin coating or ink jet printing.

An OLED device in embodiments comprises a transparent substrate on which are successively formed an anode layer, a hole injector (buffer) layer, a hole transport layer, an electroluminescent layer, an electron transport layer, an electron injection layer and an anode layer which may in turn be laminated to a second transparent substrate. Top emitting OLED's are also possible in which an aluminium or other metallic substrate carries an ITO layer, a hole injection layer, a hole transport layer, an electroluminescent layer, an electron transport layer, an electron injection layer and an ITO or other transparent cathode, light being emitted through the cathode. A further possibility is an inverted OLED in which a cathode of aluminium or aluminium alloyed with a low work function metal carries successively an electron injection layer, an electron transport layer, an electroluminescent layer, a hole transport layer, a hole injection layer and an ITO or other transparent conductive anode, emission of light being through the anode. If desired a hole blocking layer may be inserted e.g. between the electroluminescent layer and the electron transport layer. Based on the disclosure of the present invention any further layer that is known by a person skilled in the art can be used to build a device without being inventive. On skilled in the art may also establish different device architectures with, e.g., repeating or alterating layers of the same type.

Examples of additional layers are, but are not limited to, electron blocking layer, exciton blocking layer or photoabsorption layer in order to build e.g. a photodiode. Additional layer may also comprise dyes or metal complexes.

OLEDs of the invention include small molecule OLEDs, polymer light emitting diodes (p-OLEDs), OLEDs that emit light by fluorescence, OLEDs that emit light by phosphorescence (PHOLEDs) and OLEDs that emit light by ion fluorescence (rare earth complexes) and include single-colour or multi-colour active or passive matrix displays.

The OLEDs may be of the active matrix type or of the passive matrix type. A representative active matrix OLED array is described in US-A-5929474 (Huang, Motorola). That specification describes an active matrix organic light emitting device array comprising: (a) a semiconductor substrate having an array area defined thereon; (b) a plurality of field effect transistors, each including first and second current carrying terminals and a control terminal, formed in the array area on the semiconductor substrate in rows and columns, each of the rows including a row bus coupled to the first current carrying terminal of each field effect transistor in the row, and each of the columns including a column bus coupled to the control terminal of each field effect transistor in the column; (c) a planarizing layer of insulating material positioned over the plurality of field effect transistors in the array area and defining a substantially planar surface; (d) a plurality of contact pads formed on the planar surface of the planarizing layer in the array area in rows and columns, each contact pad of the plurality of contact pads associated with one field effect transistor of the plurality of field effect transistors and coupled to the second current carrying terminal of the associated field effect transistor by a conductor formed through the planar layer; (e) a plurality of layers of organic material sequentially formed in overlying relationship on the contact pads in the array area so as to define an organic light emitting device on each contact pad with each contact pad operating as a first terminal of an overlying organic light emitting device; and (f) electrical and light conducting material positioned in overlying relationship over the layers of organic material in the array area and operating as a common second terminal of the organic light emitting devices. Further references describing active matrix devices are EP-A-0717446 (Tang *et al.,* Kodak) and WO 99/65012 (Knapp et al, Philips). Choice of active or passive matrix driving may affect the selection of electrode materials, but need not fundamentally affect the choice of materials for the layers between the electrodes.

### Anode

In many embodiments the anode is formed by a layer of tin oxide or indium tin oxide coated onto glass or other transparent substrate. Other materials that may be used include antimony tin oxide and indium zinc oxide. If desired a modified anode may be produced e.g. by subsequently treating the ITO surface with oxygen plasma, and then conditioned as a modified anode by decomposing CHF₃ gas in a plasma treatment chamber to deposit an ∼1-nm-thick layer of CFₓ. In active matrix embodiments the anode may be a high work function metal or alloy e.g. gold or platinum or may be crystalline, polycrystalline, continuous grain or amorphous silicon which may be p-doped.

### Hole injection materials

A single layer may be provided between the anode and the electroluminescent material, but in many embodiments there are at least two layers one of which is a hole injection layer (buffer layer) and the other of which is a hole transport layer, the two layer structure offering in some embodiments improved stability and device life (see US-A-4720432 (VanSlyke et al., Kodak). The hole injection layer may serve to improve the film formation properties of subsequent organic layers and to facilitate the injection of holes into the hole transport layer.

Suitable materials for the hole injection layer which may be of thickness e.g. 0.1 to 200 nm depending on material and cell type include hole-injecting porphyrinic compounds - see US-A-4356429 (Tang, Eastman Kodak) e.g. zinc phthalocyanine copper phthalocyanine and ZnTpTP, whose formula is set out below:

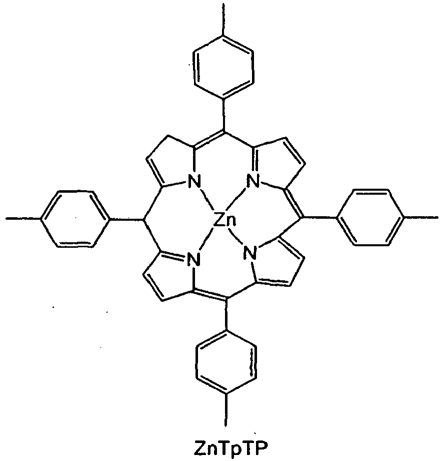

Particularly good device efficiencies, turn/on voltages and/or lifetimes may be obtained where the hole injection layer is ZnTpTP. A further material that may be used is hexacyanohexaazatriphenylene (CHATP) of structure:

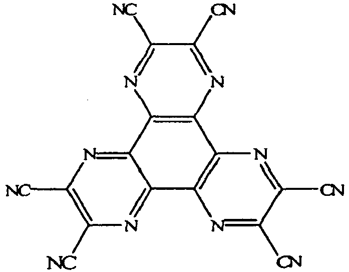

The hole injection layer may also be a fluorocarbon-based conductive polymer formed by plasma polymerization of a fluorocarbon gas - see US-A-6208075 (Hung et al; Eastman Kodak), a triarylamine polymer - see EP-A-0891121 (Inoue et al., TDK Corporation) or a phenylenediamine derivative - see EP-A-1029909 (Kawamura *et al.,* Idemitsu) or the materials described in US-A-6436559 (Ueno, Canon) and 6720573 (Se-Hwan, LG Chemical Co., Ltd.). It may also be a solution-processable hole injecting polymer e.g. PEDOT/PSS (poly-3,4-ethylenedioxythiophene doped with poly(styrenesulfonate) or a block copolymers of PEDOT and a flexible polymer such as a polyether, polysiloxane, polyester, or polyacrylate. Methods of applying such materials include spin coating, printing through a mask and ink jet printing e.g. of a relatively dilute solution where thin hole injection layers are desired. The hole injection material may also be an aromatic amine as described in US 2008/0102311 A1 such as N,N'-diphenyl-N,N'-di(3-tolyl)benzidine (= 4,4'-bis[N-3-methylphenyl]-N-phenylamino)biphenyl, NPD) (US 5061569), N,N'-bis(N,N'-diphenyl-4-aminophenyl)-N,N-diphenyl-4,4'-diamino-1,1'-biphenyl (TPD 232), and 4,4',4"-tris[3-methylphenyl)phenylamino]-triphenylamine (MTDATA) (JP Heisei 4 (1992) 308688) or an aromatic amine as described in US 7399537 B2 (HIL 1), US 2006/0061265 A1, EP 1661888 B1 (HIL2), and JP 08292586 A (HIL 3).

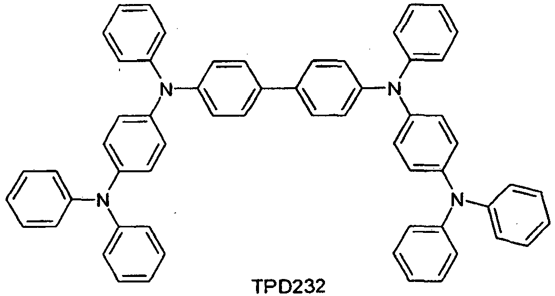

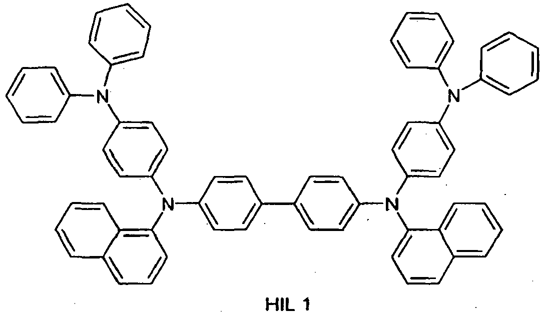

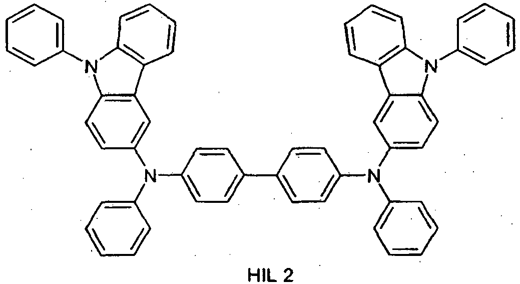

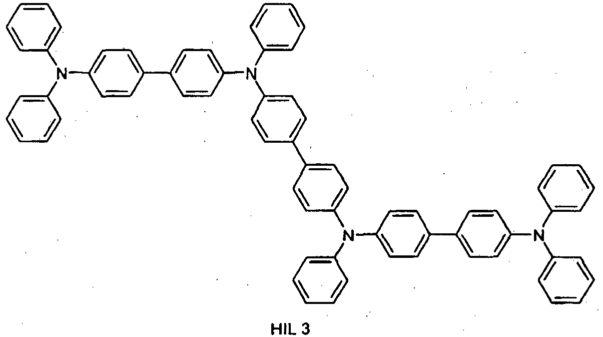

### Hole-transport materials

Hole transport layers which may be used are in some embodiments preferably of thickness 20 to 200 nm.

One class of hole transport materials comprises polymeric materials that may be deposited as a layer by means of spin coating or ink jet printing. Such polymeric hole-transporting materials include poly(*N*-vinylcarbazole) (PVK), polythiophenes, polypyrrole, and polyaniline. Other hole transporting materials are conjugated polymers e.g. poly (p-phenylenevinylene) (PPV) and copolymers including PPV. Other preferred polymers are: poly(2,5 dialkoxyphenylene vinylenes e.g. poly (2-methoxy-5-(2-methoxypentyloxy-1,4-phenylene vinylene), poly(2-methoxypentyloxy)-1,4-phenylenevinylene), poly(2-methoxy-5-(2-dodecyloxy-1,4-phenylenevinylene) and other poly(2,5 dialkoxyphenylenevinylenes) with at least one of the alkoxy groups being a long chain solubilising alkoxy group; polyfluorenes and oligofluorenes; polyphenylenes and oligophenylenes; polyanthracenes and oligoanthracenes; and polythiophenes and oligothiophenes.

A further class of hole transport materials comprises sublimable small molecules. For example, aromatic tertiary amines provide a class of preferred hole-transport materials, e.g. aromatic tertiary amines including at least two aromatic tertiary amine moieties (e.g. those based on biphenyl diamine or of a "starburst" configuration) as described in EP 1162193 B1, EP 650955 (HTL1), DE 19646119 A1 (HTL2), WO 2006/122630 A1, DE 102008024182.2 (HTL3), EP 1834945 (HTL 4), JP 08053397 A, US 6251531 (HTL5)

For example, aromatic amines may be used of the general formulae (i)-(xii) below: 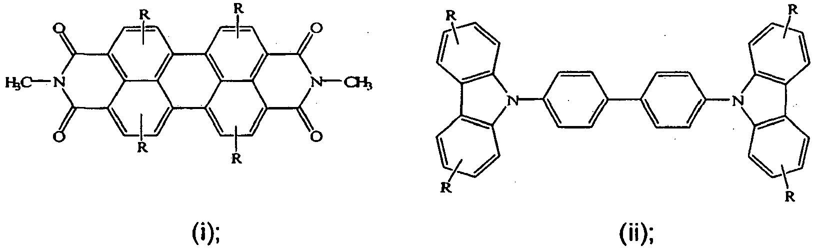 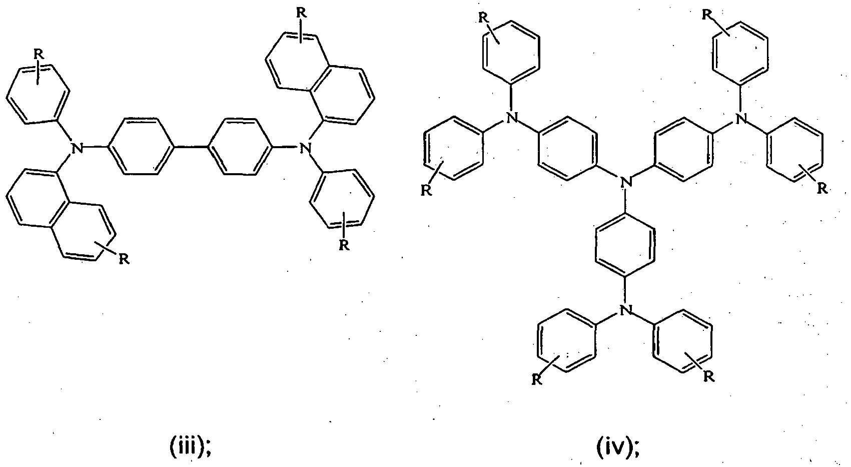 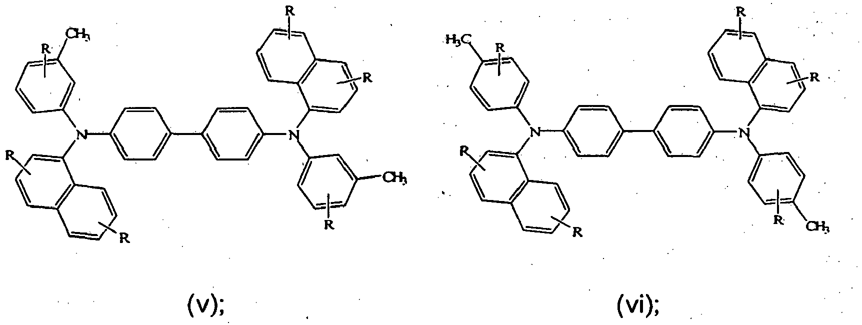 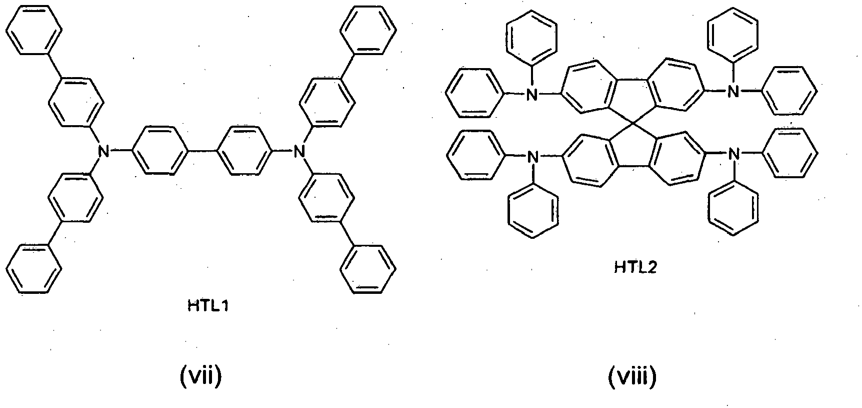 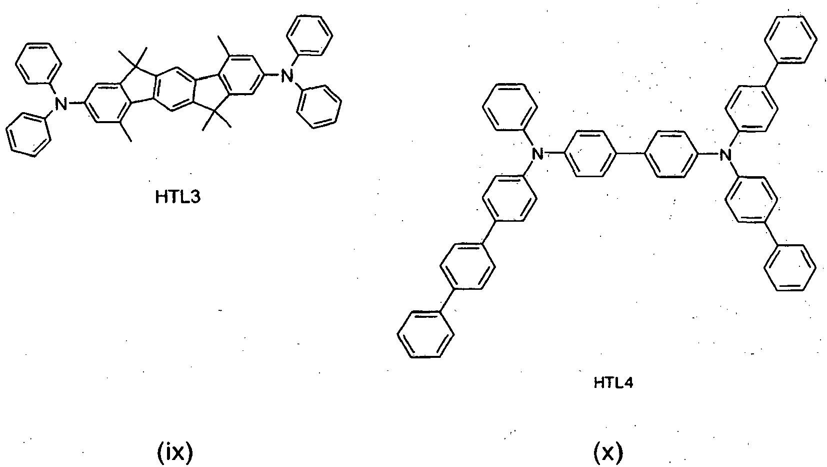 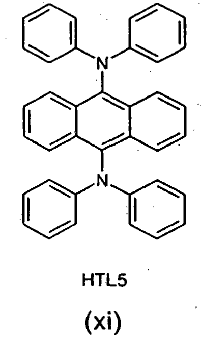 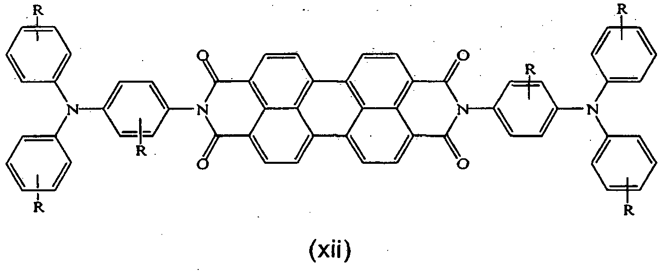 wherein
the groups R in any of the formulae in (i) to (xii) can be the same or different and are selected from hydrogen; substituted and unsubstituted aliphatic groups; substituted and unsubstituted aromatic, heterocyclic and polycyclic ring structures; halogens; and thiophenyl groups;
and wherein
in formula (i) the methyl groups may be replaced by C₁ to C₄ alkyl or monocyclic or polyclic aryl or heteroraryl which may be further substituted e.g. with alkyl, aryl or arylamino.

Further hole transport materials comprise 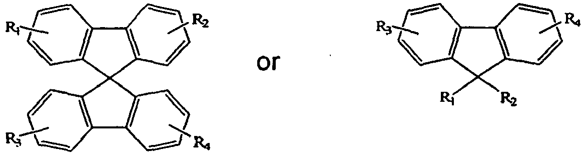 wherein
the groups R₁ to R₄ when appearing in either of the above formulae can be the same or different and are selected from hydrogen; substituted and unsubstituted aliphatic groups; substituted and unsubstituted aromatic, heterocyclic and polycyclic ring structures; halogens; and thiophenyl groups.

Particular preferred hole-transport materials are aromatic tertiary amines including at least two aromatic tertiary amine moieties (e.g. those based on biphenyl diamine or of a "starburst" configuration) of which the following are representative:

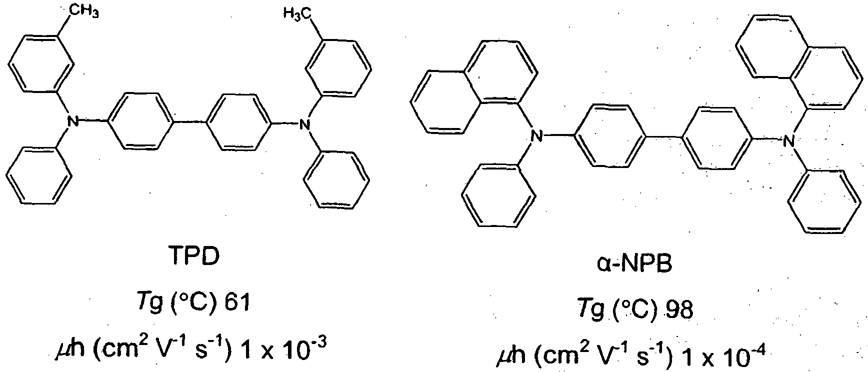

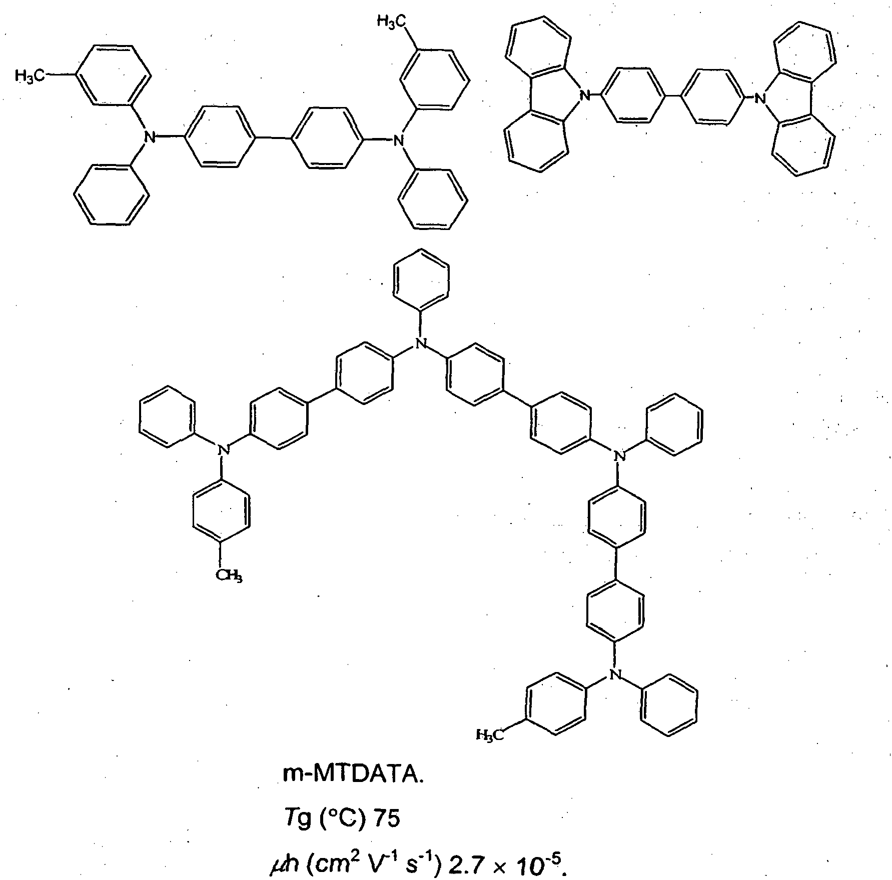

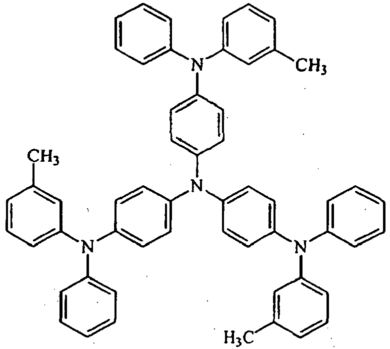

A further possible material is 4,4',4"-tris(carbazolyl)-triphenylamine (TCTA) which is a hole transport material with a wider band gap than α-NPB and which can in some embodiments assist in confining excitation to the emissive layer.

It further includes spiro-linked molecules which are aromatic amines e.g. spiro-TAD (2,2',7,7'-tetrakis-(diphenylamino)-spiro-9,9'-bifluorene). A further class of small molecule hole transport materials is disclosed in WO 2006/061594 (Kathirgamanathan et al) and is based on diamino dianthracenes. Such compounds include:
9-(10-(N-(naphthalen-1-yl)-N-phenylamino)anthracen-9-yl)-N-(naphthalen-1-yl)-N-phenylanthracen-10-amine;
9-(10-(N-biphenyl-N-2-*m*-tolylamino)anthracen-9-yl)-N-biphenyl-N-2-m-tolylamino-anthracen-10-amine; and
9-(10-(N-phenyl-N-m-tolylamino)anthracen-9-yl)-N-phenyl-N-m-tolylanthracen-10-amine.

The hole transport layer may be p-doped e.g. with an acceptor-type organic molecule e.g. tetrafluorotetracyanoquinodimethane (F₄-TCNQ) e.g. it may be starburst m-MTDATA doped with F₄-TCNQ.

### Electroluminescent materials

In principle any electroluminescent material may be used, including molecular solids which may be fluorescent dyes e.g. perylene dyes, metal complexes e.g. Alq₃, so-called "blue" aluminium quinolates of the type Alq₂L where q represents a quinolate and L represents a mono-anionic aryloxy ligand e.g. bis(2-methyl-8-quinolinolato)(4-phenyl-phenolato)Al(III), Ir(III)L₃, rare earth chelates e.g. Tb(III) complexes, dendrimers and oligomers e.g. sexithiophene, or polymeric emissive materials. The electroluminescent layer may comprise as luminescent material a metal quinolate, an iridium, ruthenium, osmium, rhodium, iridium, palladium or platinum complex, a boron complex or a rare earth complex.

One preferred class of electroluminescent materials comprises host materials doped with one or more dyes or complexes which may be fluorescent, phosphorescent or ion-phosphorescent (rare earth). The use of monoclinic zirconium quinolate described herein as host material also forms part of the invention and it may provide red and green emitters when doped with appropriate dopants, in embodiments one or more than one dopant. The term "electroluminescent device" includes electrophosphorescent devices.

Preferably the host is doped with a minor amount of a fluorescent material as a dopant, preferably in an amount of 0.01 to 25% by weight of the doped mixture. As discussed in US-A-4769292 (Tang et al.*,* Kodak), the contents of which are included by reference, the presence of the fluorescent material permits a choice from amongst a wide latitude of wavelengths of light emission. In particular, as disclosed in US-A-4769292 by blending with the organo metallic complex a minor amount of a fluorescent material capable of emitting light in response to hole-electron recombination, the hue of the light emitted from the luminescent zone, can be modified. In theory, if a host material and a fluorescent material could be found for blending which have exactly the same affinity for hole-electron recombination, each material should emit light upon injection of holes and electrons in the luminescent zone. The perceived hue of light emission would be the visual integration of both emissions. However, since imposing such a balance of host material and fluorescent materials is limiting, it is preferred to choose the fluorescent material so that it provides the favoured sites for light emission. When only a small proportion of fluorescent material providing favoured sites for light emission is present, peak intensity wavelength emissions typical of the host material can be entirely eliminated in favour of a new peak intensity wavelength emission attributable to the fluorescent material.

While the minimum proportion of fluorescent material sufficient to achieve this effect varies, in no instance is it necessary to employ more than about 10 mole percent fluorescent material, based of host material and seldom is it necessary to employ more than 1 mole percent of the fluorescent material. On the other hand, limiting the fluorescent material present to extremely small amounts, in some embodiments less than about 10⁻³ mole percent, based on the host material, can result in retaining emission at wavelengths characteristic of the host material. Thus, by choosing the proportion of a fluorescent material capable of providing favoured sites for light emission, either a full or partial shifting of emission wavelengths can be realized. This allows the spectral emissions of the EL devices to be selected and balanced to suit the application to be served. In the case of fluorescent dyes, in some embodiments amounts are 0.01 to 5 wt%, for example 2 to 3 wt%. In the case of phosphorescent dyes amounts in some embodiments are 0.1 to 15 wt%. In the case of ion phosphorescent materials amounts in some embodiments are 0.01 to 25 wt% or up to 100 wt%.

Choosing fluorescent materials capable of providing favoured sites for light emission necessarily involves relating the properties of the fluorescent material to those of the host material. The host can be viewed as a collector for injected holes and electrons with the fluorescent material providing the molecular sites for light emission. One important relationship for choosing a fluorescent material capable of modifying the hue of light emission when present in the host is a comparison of the reduction potentials of the two materials. The fluorescent materials demonstrated to shift the wavelength of light emission have exhibited a less negative reduction potential than that of the host. Reduction potentials, measured in electron volts, have been widely reported in the literature along with varied techniques for their measurement. Since it is a comparison of reduction potentials rather than their absolute values which is desired, it is apparent that any accepted technique for reduction potential measurement can be employed, provided both the fluorescent and host reduction potentials are similarly measured. A preferred oxidation and reduction potential measurement techniques is reported by R. J. Cox, Photographic Sensitivity, Academic Press, 1973, Chapter 15.

A second important relationship for choosing a fluorescent material capable of modifying the hue of light emission when present in the host is a comparison of the band-gap potentials of the two materials. The fluorescent materials demonstrated to shift the wavelength of light emission have exhibited a lower band gap potential than that of the host. The band gap potential of a molecule is taken as the potential difference in electron volts (eV) separating its ground state and first singlet state. Band gap potentials and techniques for their measurement have been widely reported in the literature. The band gap potentials herein reported are those measured in electron volts (eV) at an absorption wavelength which is bathochromic to the absorption peak and of a magnitude one tenth that of the magnitude of the absorption peak. Since it is a comparison of band gap potentials rather than their absolute values which is desired, it is apparent that any accepted technique for band gap measurement can be employed, provided both the fluorescent and host band gaps are similarly measured. One illustrative measurement technique is disclosed by F. Gutman and L. E. Lyons, Organic Semiconductors, Wiley, 1967, Chapter 5.

With host materials which are themselves capable of emitting light in the absence of the fluorescent material, it has been observed that suppression of light emission at the wavelengths of emission characteristics of the host alone and enhancement of emission at wavelengths characteristic of the fluorescent material occurs when spectral coupling of the host and fluorescent material is achieved. By "spectral coupling" it is meant that an overlap exists between the wavelengths of emission characteristic of the host alone and the wavelengths of light absorption of the fluorescent material in the absence of the host. Optimal spectral coupling occurs when the emission wavelength of the host is within ± 25 nm of the maximum absorption of the fluorescent material alone. In practice advantageous spectral coupling can occur with peak emission and absorption wavelengths differing by up to 100 nm or more, depending on the width of the peaks and their hypsochromic and bathochromic slopes. Where less than optimum spectral coupling between the host and fluorescent materials is contemplated, a bathochromic as compared to a hypsochromic displacement of the fluorescent material produces more efficient results.

Useful fluorescent materials are those capable of being blended with the host and fabricated into thin films satisfying the thickness ranges described above forming the luminescent zones of the EL devices of this invention. While crystalline organometallic complexes do not lend themselves to thin film formation, the limited amounts of fluorescent materials present in the host permit the use of fluorescent materials which are alone incapable of thin film formation. Preferred fluorescent materials are those which form a common phase with the host. Fluorescent dyes constitute a preferred class of fluorescent materials, since dyes lend themselves to molecular level distribution in the host. Although any convenient technique for dispersing the fluorescent dyes in the host can be used preferred fluorescent dyes are those which can be vacuum vapour deposited along with the host materials. One class of host materials comprises metal complexes e.g. metal quinolates such as lithium quinolate, aluminium quinolate, titanium quinolate, zirconium quinolate or hafnium quinolate which may be doped with fluorescent materials or dyes as disclosed in patent application WO 2004/058913.

Common host materials are, for instance, selected from carbazols, ketones, phosphinoxides, sufoxides, bipolar hosts, and oligoarylenes selected from anthracenes, dinaphthyl anthracenes, benzanthracene anthracenes, tetraphenylspirobifluorenes.

In the case of hosts which comprise quinolates e.g. aluminium quinolate or "blue" quinolates, see e.g. J.C. Deaton et al., Inorg. Chim. Acta (2007), doi:10.1016/j.ica.2007.07.008:
Common dopants are, for instance, selected from phosphorescent emitters, diphenylacridine, coumarins, perylene, quinolates, porphoryin, porphines, pyrazalones and derivatives thereof, aryl amines preferably indenofluorene monoamines and -diamines, benzofluorene monoamines and -diamines and dibenzoindenofluorene monoamines and -diamines
   (a) the compounds below, for example, can serve as red dopants: 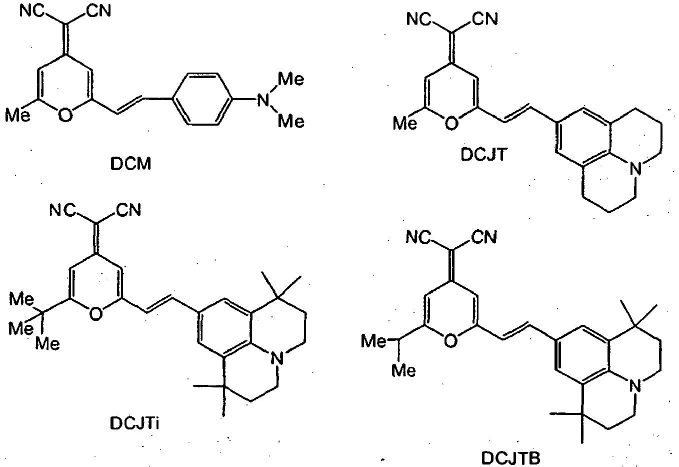 wherein
      Me is a methyl group
   (b) the compounds below, for example can serve as green dopants: 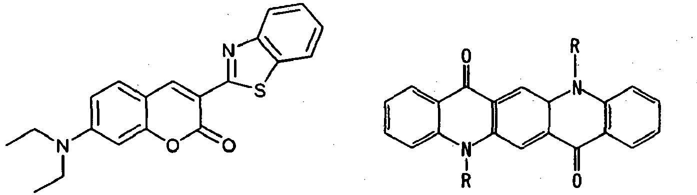 wherein
      R is C₁ to C₄ alkyl, monocyclic aryl, bicycic aryl, monocyclic heteroaryl, bicyclic heteroaryl, aralkyl or thienyl, preferably phenyl; and
   (c) for biphenyloxy aluminium bis-quinolate (BAlq₂) or aluminium quinolate the compounds perylene and 9-(10-(N-(naphthalen-8-yl)-N-phenylamino)anthracen-9-yl)-N-(naphthalen-8-yl)-N-phenylanthracen-10-amine can serve as a blue dopants.

Another preferred class of hosts is small molecules incorporating conjugated aromatic systems with e.g. 4 to 10 aryl or heteroaryl rings which may bear substituents e.g. alkyl (especially methyl), alkoxy and fluoro and which may also be doped with fluorescent materials or dyes.
An example of a system of the above kind is a blue-emitting material based on the following compound (Compound H) as host 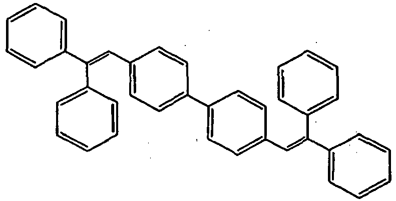 and perylene or 9-(10-(N-(naphthalen-8-yl)-N-phenylamino)anthracen-9-yl)-N-(naphthalen-8-yl)-N-phenylanthracen-10-amine as dopant. Further examples of host materials which are small aromatic molecules are shown below: 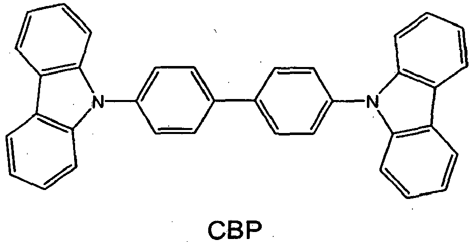 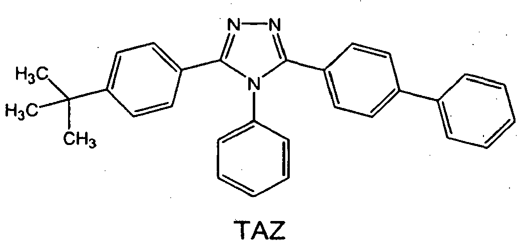 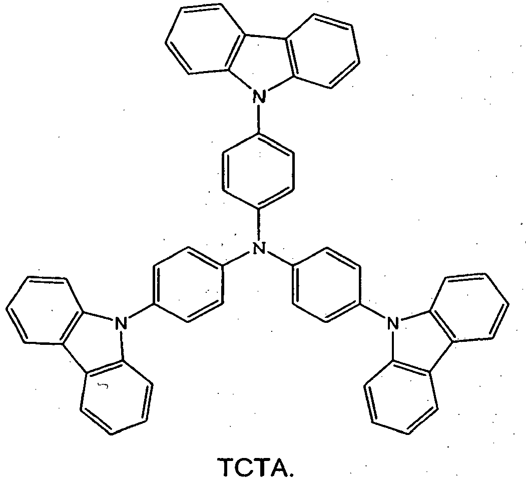 2,9-Bis(2-thiophen-2-yl-vinyl)-[1,10]phenanthroline may, as explained above, may be used as host in the electroluminescent layer or may be present on its own.

Other suitable host materials for fluourescent dopants may be chosen out of the class of oligoarylenes like dinaphthyl anthracenes, benzanthracene-anthracenes as described in WO 2008/145239, tetraphenylspirobifluorenes as described in EP 676461, anthracen based compounds as described in US 2007/0092753, US 2007/0092753, US 2007/0252517, US 2008/0193796, US 2003/0027016, US 7326371, US 2006/043858, and US 2003/0027016. Preferred compounds from theses references are the compounds of the following formulae

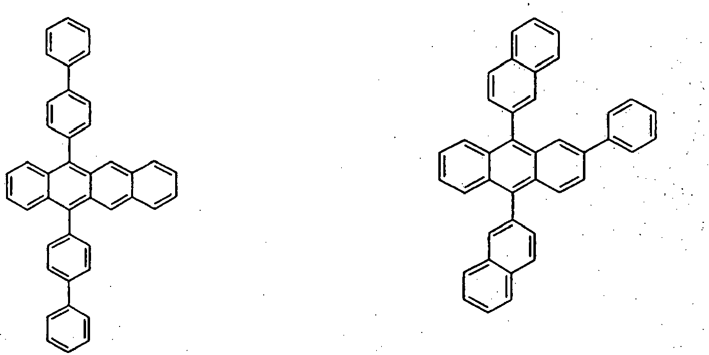

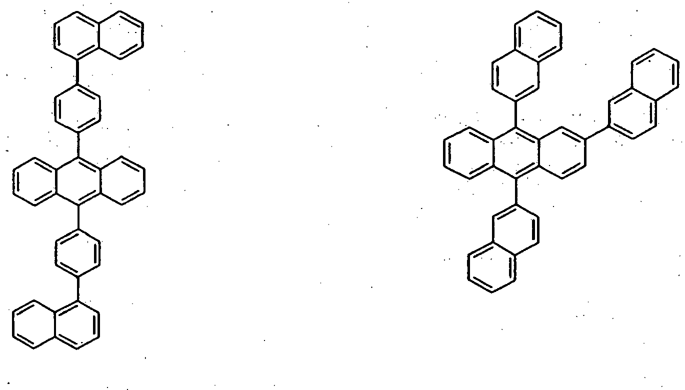

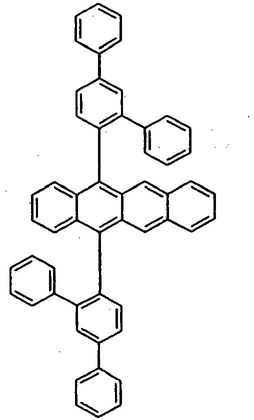

Blue-emitting materials may be based on an organic host (e.g. a conjugated aromatic compound as indicated above) and diarylamine anthracene compounds disclosed in WO 2006/090098 (Kathirgamanathan *et al.*) as dopants. For example, CBP may be doped with blue-emitting substituted anthracenes inter *alia* 9,10-bis(-4-methylbenzyl)-anthracene, 9,10-bis-(2,4-dimethylbenzyl)-anthracene, 9,10-bis-(2,5-dimethylbenzyl)-anthracene, 1,4-bis-(2,3,5,6-tetramethylbenzyl)-anthracene, 9,10-bis-(4-methoxybenzyl)-anthracene, 9,10-bis-(9H-fluoren-9-yl)-anthracene, 2,6-di-t-butylanthracene, 2,6-di-t-butyl-9,10-bis-(2,5-dimethylbenzyl)-anthracene, 2,6-di-t-butyl-9,10-bis-(naphthalene-1-ylmethyl)-anthracene.

Other blue emitting materials may be chosen out of indenofluorene monoamines and -diamines as described in WO 2006/122630, benzofluorene monoamines and -diamines as described in WO 2008/006449 and dibenzoindenofluorene mono- and diamines as disclosed in WO 2007/140847. The emitters may also be styrylamines as described in DE 2005/058557, US 7250532, or aryldiamines as described inUS 2006/21830, JP 08053397, US 6251531, EP 1957606, US 2008/0113101, and CN 1583691. Preferred compounds of the cited references are the following compounds having the formulae

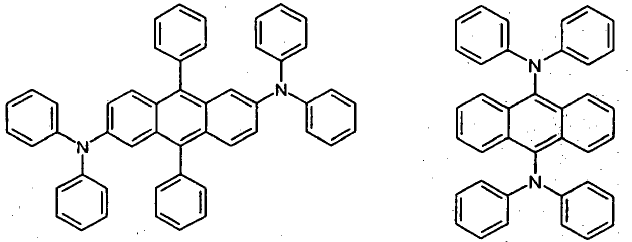

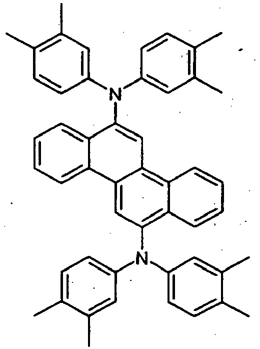

Further blue-emitting materials may use TCTA ,or further carbazol derivatives as described in WO 2008/086851, EP 1617710, EP 1617711, EP 1731584, JP 2005/347160, or ketones as described in WO 2004/093207, or be chosen from phoshine oxides and sufoxides as described in WO 2005/003253 or from bipolar host materials as described in WO 2007/137725 or from metal chelates as described in EP 652273, e.g. 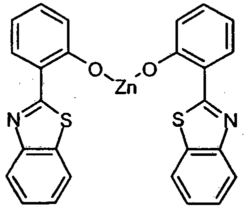 as hosts and it may be doped with the blue phosphorescent materials set out below, see WO 2005/080526 (Kathirgamanathan et al.) or with phosphorescent emitters as described WO 00/70655, WO 01/41512, WO 02/02714, WO 02/15645, EP 1191613, EP 1191612, EP 1191614 and WO 05/033244 or described in US 2007-0087219 A1, US 2009/0061681 A1, US 2009/0061681 A1, US 2001 0053462 A1 or out of Baldo, Thompson et al Nature 403 (2000), 750-753 or as described in Adachi et al Appl. Phys. Lett. 78 (2001), 1622-24, US 6824895, US 10/729238, US 6835469, US 2001 0053462 A1 :

### Blue Phosphorescent Materials

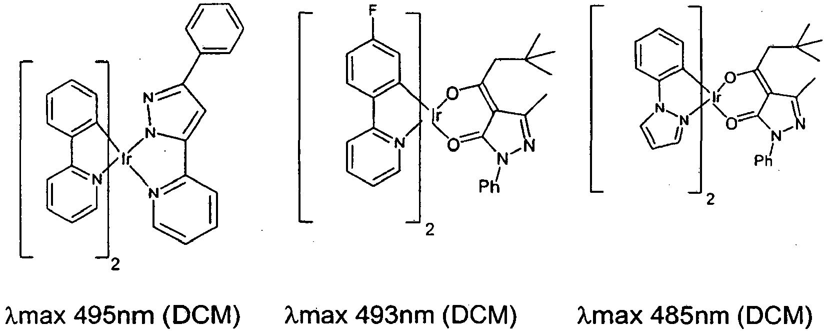

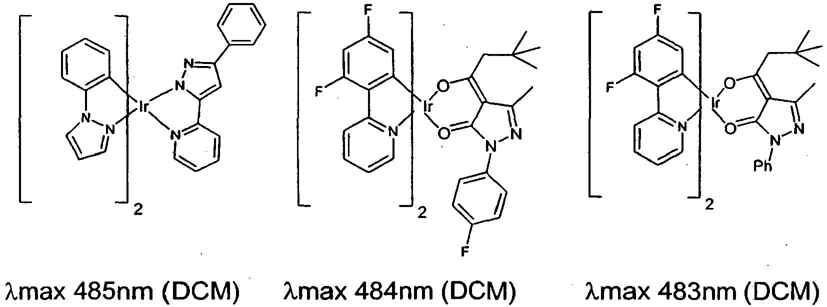

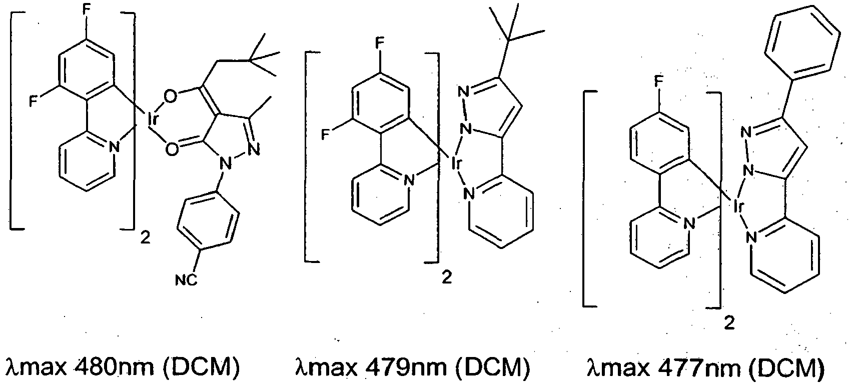

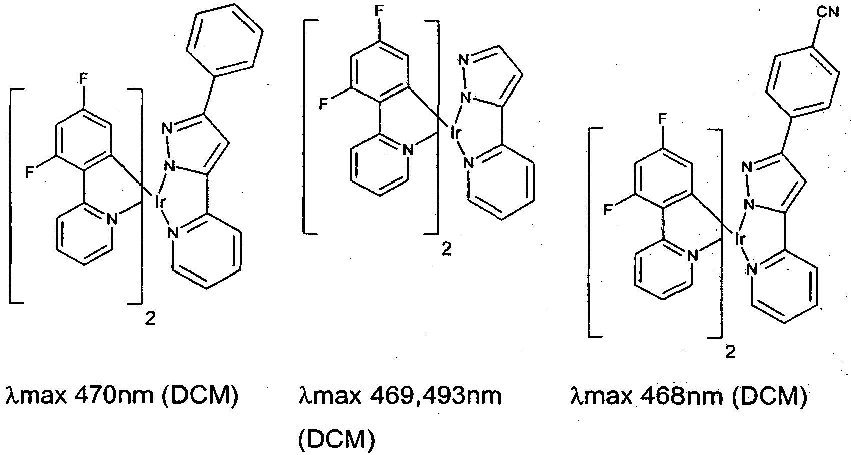

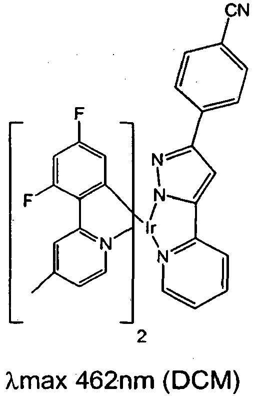

Examples of green phosphorescent materials that may be employed with CBP or TAZ are set out below (see WO 2005/080526):

### Green Phosphorescent Materials

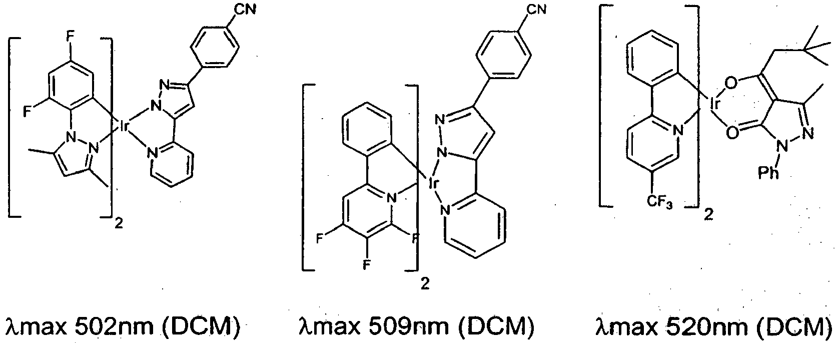

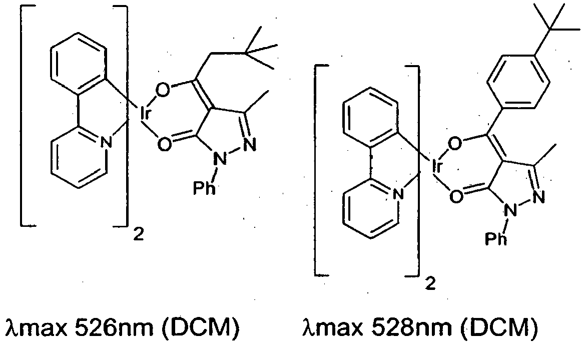

wherein
Ph is a phenyl group.

Examples of red phosphorescent materials that may be employed with CBP or TAZ are set out below (see WO 2005/080526):

### Red Phosphorescent Materials

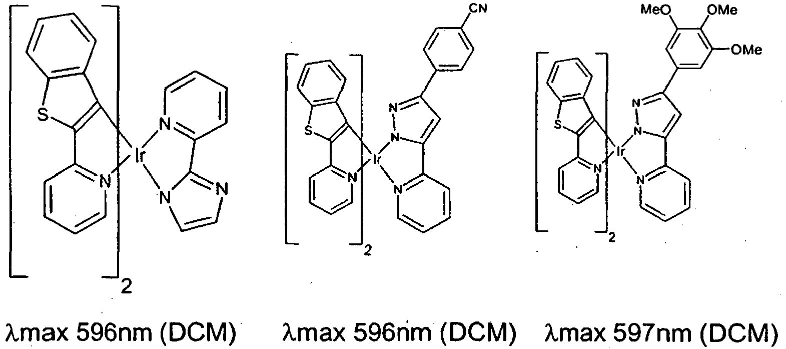

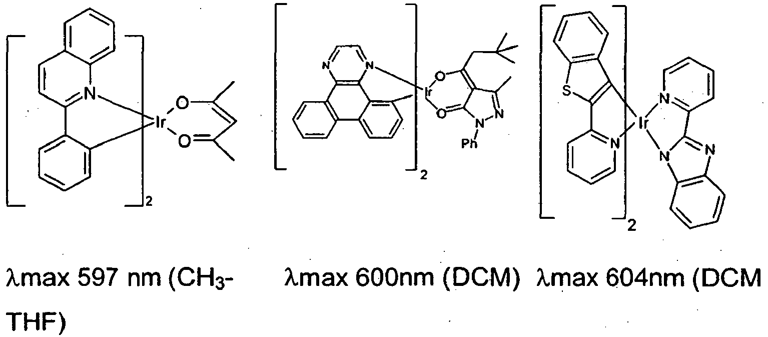

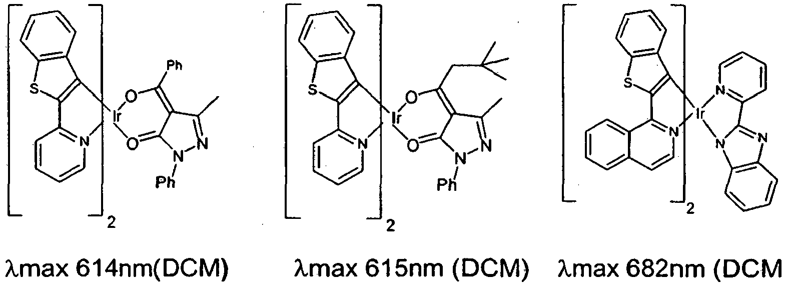

wherein
Ph is a phenyl group
and wherein Me is a methyl group

As further dopants, fluorescent laser dyes are recognized to be particularly useful fluorescent materials for use in the organic EL devices of this invention. Dopants which can be used include diphenylacridine, coumarins, perylene and their derivatives. Useful fluorescent dopants are disclosed in US 4769292. One class of preferred dopants is coumarins. The following are illustrative fluorescent coumarin dyes known to be useful as laser dyes:
- FD-1: 7-Diethylamino-4-methylcoumarin,
- FD-2: 4,6-Dimethyl-7-ethylaminocoumarin,
- FD-3: 4-Methylumbelliferone,
- FD-4: 3-(2'-Benzothiazolyl)-7-diethylaminocoumarin,
- FD-5: 3-(2'-Benzimidazolyl)-7-N,N-diethylaminocoumarin,
- FD-6: 7-Amino-3-phenylcoumarin,
- FD-7: 3-(2'-N-Methylbenzimidazolyl)-7-N,Ndiethylaminocoumarin,
- FD-8: 7-Diethylamino-4-trifluoromethylcoumarin,
- FD-9: 2,3,5,6-1 H,4H-Tetrahydro-8-methylquinolazino[9,9a,1-gh]coumarin,
- FD-10: Cyclopenta[c]julolindino[9,10-3]-11H-pyran-11-one,
- FD-11: 7-Amino-4-methylcoumarin,
- FD-12: 7-Dimethylaminocyclopenta[c]coumarin,
- FD-13: 7-Amino-4-trifluoromethylcoumarin,
- FD-14: 7-Dimethylamino-4-trifluoromethylcoumarin,
- FD-15: 1,2,4,5,3H,6H,10H-Tetrahydro-8-trifluoromethyl[1]benzopyrano[9,9a,1-gh]quinolizin-10-one,
- FD-16: 4-Methyl-7-(sulfomethylamino)coumarin sodium salt,
- FD-17: 7-Ethylamino-6-methyl-4-trifluoromethylcoumarin,
- FD-18: 7-Dimethylamino-4-methylcoumarin,
- FD-19: 1,2,4,5,3H,6H,10H-Tetrahydro-carbethoxy[1]benzopyrano[9,9a,1-gh]quinolizino-10-one,
- FD-20: 9-Acetyl-1,2,4,5,3H,6H,10H-tetrahydro[1]benzopyrano[9,9a,1-gh]quinolizino-10-one,
- FD-21: 9-Cyano-1,2,4,5,3H,6H,10H-tetrahydro[1]benzopyrano[9,9a,1-gh]quinolizino-10-one,
- FD-22: 9-(t-Butoxycarbonyl)-1,2,4,5,3H,6H,10H-tetrahyro[1]-benzopyrano-[9,9a,1-gh]quinolizino-10-one,
- FD-23: 4-Methylpiperidino[3,2-g]coumarin,
- FD-24: 4-Trifluoromethylpiperidino[3,2-g]coumarin,
- FD-25: 9-Carboxy-1,2,4,5,3H,6H,10H-tetrahydro[1]benzopyrano[9,9a,1-gh]quinolizino-10-one,
- FD-26: N-Ethyl-4-trifluoromethylpiperidino[3,2-g].

Other dopants include salts of bis benzene sulphonic acid (require deposition by spin-coating rather than sublimation) such as 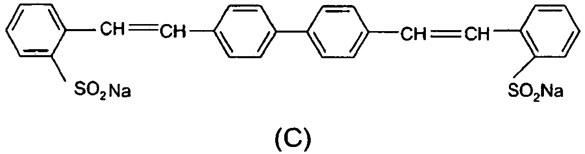 and perylene and perylene derivatives and dopants. Other dopants are dyes such as the fluorescent 4-dicyanomethylene-4H-pyrans and 4-dicyanomethylene-4H-thiopyrans,e.g. the fluorescent dicyanomethylenepyran and thiopyran dyes. Useful fluorescent dyes can also be selected from among known polymethine dyes, which include the cyanines, complex cyanines and merocyanines (i.e. tri-, tetra- and polynuclear cyanines and merocyanines), oxonols, hemioxonols, styryls, merostyryls, and streptocyanines. The cyanine dyes include, joined by a methine linkage, two basic heterocyclic nuclei, such as azolium or azinium nuclei, for example, those derived from pyridinium, quinolinium, isoquinolinium, oxazolium, thiazolium, selenazolium, indazolium, pyrazolium, pyrrolium, indolium, 3H-indolium, imidazolium, oxadiazolium, thiadioxazolium, benzoxazolium, benzothiazolium, benzoselenazolium, benzotellurazolium, benzimidazolium, 3H- or 1 H-benzoindolium, naphthoxazolium, naphthothiazolium, naphthoselenazolium, naphthotellurazolium, carbazolium, pyrrolopyridinium, phenanthrothiazolium, and acenaphthothiazolium quaternary salts. Other useful classes of fluorescent dyes are 4-oxo-4H-benz-[d,e]anthracenes and pyrylium, thiapyrylium, selenapyrylium, and telluropyrylium dyes. Further blue-emitting materials are disclosed in the following patents, applications and publications:
US-A-5141671 (Bryan, Kodak) - Aluminium chelates containing a phenolato ligand and two 8-quinolinolato ligands.
WO 00/32717 (Kathirgamanathan) - Lithium quinolate which is vacuum depositable, and other substituted quinolates of lithium where the substituents may be the same or different in the 2,3,4,5,6 and 7 positions and are selected from alky, alkoxy, aryl, aryloxy, sulphonic acids, esters, carboxylic acids, amino and amido groups or are aromatic, polycyclic or heterocyclic groups.
US 2006/0003089 (Kathirgamanathan) - Lithium quinolate made by reacting a lithium alkyl or alkoxide with 8-hydroxyquinoline in acetonitrile.

Misra A. et al U.R.S.I. GA 2005, "Synthesis and characterisation of blue organic electroluminesent bis (2-methyl 8-quinolinolato) (triphenyl Siloxy) aluminium for OLEDs applications"; see the following website: http://www.ursi.org/Proceedings/ProcGA05/pdf/D04.5(01720).pdf - Blue organic electroluminescent material bis-(2-methyl 8-quinolinolato) (triphenyl siloxy)aluminium (III) vacuum depositable at 1 x 10⁻⁵ Torr. WO 03/006573 (Kathirgamanathan et al) - Metal pyrazolones. WO 2004/084325 (Kathirgamanathan et al) - Boron complexes. WO 2005/080526 (Kathitgamanathan et al) *-* Blue phosphorescent iridium-based complexes. Ma et al., Chem. Comm. 1998, 2491-2492 Preparation and crystal structure of a tetranuclear zinc(II) compound [Zn₄O(AlD)₆] with 7-azaindolate as a bridging ligand. Fabrication of inter alia a single-layer LED by vacuum deposition of this compound (< 200 °C, 2 x 10⁻⁶ Torr) onto a glass substrate coated with indium-tin oxide to form a thin homogeneous film was reported.

Further electroluminescent materials which can be used include metal quinolates such as aluminium quinolate, lithium quinolate, titanium quinolate, zirconium quinolate, hafnium quinolate etc..

Many further electroluminescent materials that may be used are disclosed in WO 2004/050793 (pyrazolones), WO 2004/058783 (diiridium metal complexes), WO 2006/016193 (dibenzothiophenyl metal complexes) and WO 2006/024878 (thianthrene metal complexes); see also WO 2006/ 040593. Rare earth chelates, in particular may be employed as green and red emitters. Furthermore, there may be used as electroluminescent materials conducting polymers e.g phenylene vinylene polymers, fluorene homopolymers and copolymers, phenylene polymers, as indicated below:

### Conducting Polymers

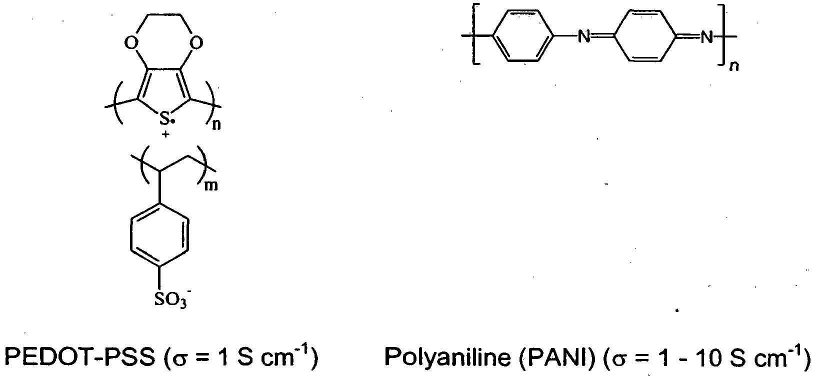

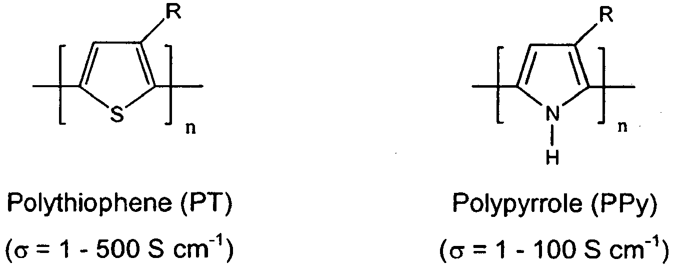

Mixed host materials have also been disclosed in the literature and may be used in OLEDs devices according to the invention. Various references disclose additives and mixed hosts for OLED's in an attempt to further improve properties. Jarikov et al., J. Appl. Phys., 100, 014901 (2006) discloses flat and rigid polycyclic aromatic hydrocarbons (PAHs) as LEL additives e.g. perylene.

Jarikov et al. further report J. Appl. Phys., 100, pp. 094907-094907-7 (2006) perylene derivatives as light-emitting-layer (LEL) additives in organic light-emitting diodes (OLEDs). These molecules readily form emissive aggregates when added to the LEL. Addition of these polycyclic aromatic hydrocarbons increases the half-life (t₅₀) of undoped and doped OLEDs by 30 to 150 times e.g. in an Alq₃+dibenzo[b,k]perylene mixed host. The authors yet further report in J. Appl. Phys., 102, 104908 (2007) a synergistic effect of a lifetime-extending light-emitting-layer (LEL) additive and improved electron injection and transport in organic light-emitting diodes (OLEDs). Di-(2-naphthyl)perylene (DNP) serves as a LEL additive said to extend the operating lifetime of OLEDs by over two orders of magnitude. Using 2-phenyl-9,10-di(2-naphthyl)anthracene (PADN) as an electron-transport layer (ETL) and a separate layer of 4,7-diphenyl-1,10-phenanthroline (BPhen) as an electron-injection layer (EIL) the authors claimed to have significantly improved electron delivery into the charge recombination zone relative to traditional ETL made of tris(8-quinolinolate)aluminium (Alq). See also US-A-7175922 (Jarikov et al).

J.C. Deaton et al (*supra*) disclose an α-NPB host with a "blue" aluminium quinolate as co-host and an iridium dopant. Very good yields were obtained with low concentrations of dopant for phosphorescent devices and it was found that the mixed host device provided increased power efficiency. It was hypothesized that the explanation was a reduction in the energy barrier to inject holes into the emissive layer by mixing the hole-transporting NPB having an ionization potential of 5.40 eV into the dominantly electron-transporting "blue" aluminium quinolates, having a higher ionization potential of 6.02 eV.

US-A-6392250 (Aziz et al) discloses organic light emitting devices comprising a mixed region comprising a mixture of a hole transport material e.g. an aromatic tertiary amine, an electron transport material e.g. a quinolate and a dopant material. For example N,N'-di-1-naphthyl-N,N'-diphenyl-1,1'-biphenyl-1,1'-biphenyl-4,4'-diamine (NPB), and tris (8-hydroxyquinoline) aluminium (Alq₃) may be used as the hole transport material and the electron transport material, respectively and N,N'-dimethylquinacridone (DMQ), 5,6,11,12-tetraphenylnapthacene (Rubrene), and Nile-red dye (available from Aldrich Chemicals of Milwaukee, Wis.) may be used as dopants.

US 2002/0074935 (Kwong et al) also discloses devices with an emissive layer containing PtOEP or bis(benzothienyl-pyridinato-NnC)Iridium(III) (acetylacetonate) as a dopant and equal proportions of NPB and Alq as host materials. It is explained that the mixed host electroluminescent mixed layer serves to substantially reduce the accumulation of charge that is normally present at the heterojunction interface of heterostructure devices, thereby reducing organic material decomposition and enhancing device stability and efficiency.

In US 2004/0155238 (Thompson et al.) a light emitting layer of the OLED device contains a wide band gap inert host matrix in combination with a charge carrying material and a phosphorescent emitter. The charge carrying compound can transport holes or electrons, and it is selected so that charge carrying material and phosphorescent emitter transport charges of opposite polarity.

M. Furugori et al. in US 2003/0141809 disclose phosphorescent devices where a host material is mixed with another hole- or electron transporting material in the light emitting layer. The document discloses that devices utilizing plural host compounds show higher current and higher efficiencies at a given voltage.

T. Igarashi et al. in WO 2004/062324 disclose phosphorescent devices with the light emitting layer containing at least one electron transporting compound, at least one hole transporting compound and a phosphorescent dopant.

WO 2006/076092 (Kondakova et al.) discloses OLED device comprising a cathode, an anode, and located therebetween a light emitting layer (LEL) comprising at least one hole transporting co-host e.g. an aromatic tertiary amine such as 4,4'-Bis[N-(I-naphthyl)-N-phenylamino]biphenyl (NPB), 4,4'-Bis[N-(1-naphthyl)-N-(2-naphthyl)amino]biphenyl (TNB), 4,4'-Bis[N-(3-methylphenyl)-N-phenylamino-]biphenyl (TPD), 4,4'-Bis-diphenylamino-terphenyl or 2,6,2',6'-tetramethyl-N,N,N',N'-tetraphenyl-benzidine.and at least one electron transporting co-host e.g. a substituted 1,2,4-triazole such as 3- phenyl-4-(1-naphtyl)-5-phenyl-1,2,4-triazole or a substituted 1,3,5-triazine such as 2,4,6-tris(diphenylamino)-1,3,5-triazine, 2,4,6-tricarbazolo-1,3 ,5-triazine, 2,4,6-tris(N-phenyl-2-naphthylamino)-1,3,5-triazine, 2,4,6-tris(N-phenyl-1-naphthylamino)-1,3,5-triazine and 4,4',6,6'-tetraphenyl-2,2'-bi-1,3,5-triazine together with a phosphorescent emitter, wherein the triplet energy of each of the co-host materials is greater than the triplet energy of the phosphorescent emitter, and further containing an exciton blocking layer comprising a hole transporting material with triplet energy greater or equal to 2.5 eV adjacent the emitting layer on the anode side, which may be a substituted triarylamine e.g. 4,4',4"-tris[(3-methylphenyl)-phenylamino]triphenylamine (MTDATA), 4,4',4"-tris(N,N-diphenyl-amino)triphenylamine (TDATA), N,N-bis[2,5-dimethyl-4-[(3-methylphenyl)-phenylamino]phenyl]-2,5-dimethyl-N'-(3-methylphenyl)-N'-phenyl-1,4-benzenediamine. The devices are said to exhibit improved efficiency and reduced drive voltage.

US-A-7045952 (Lu, Universal Display Corporation) discloses an organic light emissive device comprising an emissive region disposed between and electrically connected to an anode and a cathode, wherein the emissive region comprises (i) a first single-host emissive layer, comprising a first host material, and (ii) a mixed-host emissive layer in direct contact with the first single-host emissive layer, wherein the mixed-host emissive layer comprises the first host material, and a second host material, and wherein the first single-host emissive layer and the mixed-host emissive layer each further comprise a phosphorescent emissive material.

### Electron transport material

Monoclinic zirconium quinolate may be the totality, or substantially the totality of the electron transport layer. It may be a mixture of co-deposited materials which is predominantly monoclinic zirconium quinolate. The zirconium quinolate may be doped as described in GB 2006/14847.2. Suitable dopants include fluorescent or phosphorescent dyes or ion fluorescent materials e.g. as described above in relation to the electroluminescent layer, e.g. in amounts of 0.01 to 25 wt% based on the weight of the doped mixture. Other dopants include metals which can provide high brightness at low voltage.

Additionally or alternatively, the monoclinic zirconium quinolate may be used in admixture with another electron transport material. Such materials may include complexes of metals in the trivalent or pentavalent state which should further increase electron mobility and hence conductivity. The zirconium quinolate may be mixed with a quinolate of a metal of group 1, 2, 3, 13 or 14 of the periodic table, e.g. lithium quinolate or zinc quinolate. The zirconium may also be mixed with at least one further electron transport material, preferably selected from benzimidazoles and quinolates of Li, Al, Ga, Mg, Zn, and Be, particularly preferably lithium quinolate. Additionally the electron transport material may be n-doped e.g. with donor-type organic molecules. Preferably the zirconium quinolate comprises at least 30 wt% of the electron transport layer, more preferably at least 50 wt%.

The electron transport materials may also be chosen out of the benzimidazole class as described in US 5766779, US 5529853, US 6878469, US 20056/147747 and out of EP 1551206, e.g.

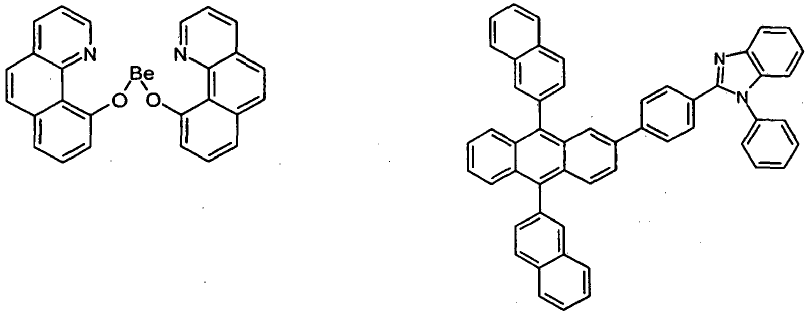

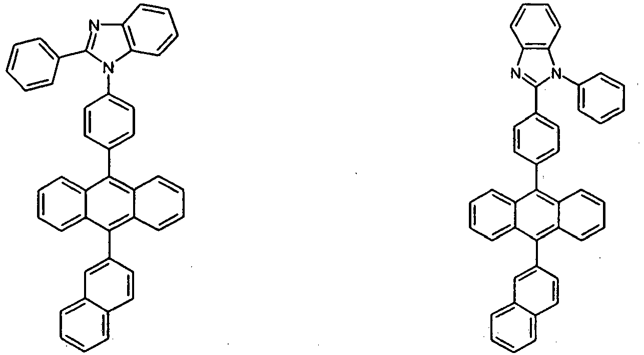

### Electron injection material

Any known electron injection material may be used, LiF being used in some embodiments. Other possibilities include BaF₂, CaF₂ and CsF₂. A further class of electron injectors comprises sublimable or coatable e.g. spin-coatable small molecules with electron injection properties. Embodiments of a layer of small molecule electron injection material are about 0.3 to 2 nm in thickness, in some particular embodiments about 0.3 nm in thickness and in other embodiments about 0.5 to 1 nm in thickness and preferably has a work function of less than magnesium 3.7 eV, this being regarded for present purposes as a low work function. In some embodiments the electron injection material may be doped with a low work function metal e.g. lithium, potassium or caesium. In the case of a lithium-based small molecule electron injection material, doping may be with metallic lithium.

Metal quinolates can lower the work function of the cathode, enable the electroluminescent device to operate at a lower voltage and improve the lifetime and performance of the device. In some embodiments quinolates and derivatives thereof have been found superior to the previously used lithium fluoride. They have significantly lower evaporation temperatures, as is apparent from the table below (q represents quinolate):

| Material | Evaporation Temparature / ⁰C | Vacuum Pressure / Pa | Evaporation Rate / Å s⁻¹ |
|---|---|---|---|
| Liq | 320 | ≤ 5 x 10⁻⁵ | 1.0 |
| LiF | 580 | ≤ 5 x 10⁻⁵ | 0.1 |

Suitable metal quinolates include the alkali metal quinolates and the alkaline earth quinolates. Preferred quinolates are quinolates of Li, Ga, Mg, Zn, and Be. Preferred metal quinolates have the formula 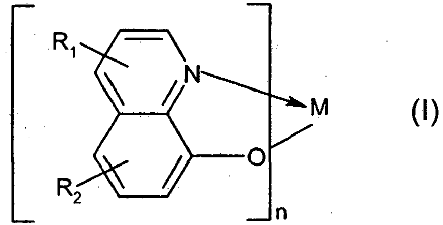 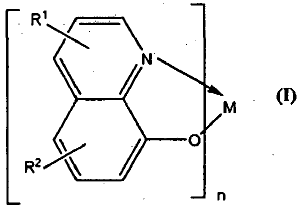 wherein
M is a metal (in embodiments lithium);
n is the valence state of M when complexed with quinolate;
and R₁ and R₂ which may be the same or different are selected from C₁ to C₄ alkyl and substituted or unsubstituted monocyclic or polycyclic aryl or heteroaryl, aralk-(C₁ to C₄)-yl or aryloxy.

Lithium quinolate and lithium 2-methylquinolate are preferred compounds and are preferably the result of reaction between a lithium alkyl or alkoxide with substituted or unsubstituted 8-hydroxy quinoline in a solvent which comprises acetonitrile. Lithium quinolates made as described above are of high purity and readily sublimable.

The electron injection layer deposited direct onto the cathode may alternatively comprise a compound of the formula 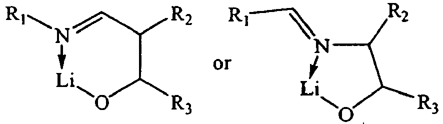 wherein
R₁ is a 1 to 5 ring aryl (including polycyclic aryl or aryl-substituted polycyclic aryl), aralkyl or heteroaryl group which may be substituted with one or more C₁ to C₄ alkyl or alkoxy substituents;
and R₂ and R₃ together form a 1 to 5 ring aryl (including polycyclic or aryl-substituted polycyclic aryl), aralkyl or heteroaryl group which may be substituted with one or more C₁ to C₄ alkyl or alkoxy substituents.

A compound of the above formula may be used alone or in combination with another electron injection material e.g. a quinolate such as lithium or zirconium quinolate. The Schiff base preferably comprises at least 30 wt% of the electron injection layer, more preferably at least 50 wt%.

In the formula set out above, R₁ may be polycyclic aryl e.g. naphthyl, anthracenyl, tetracenyl, pentacenyl or a perylene or pyrene compound or may have up to 5 aromatic rings arranged in a chain e.g. biphenyl. It is preferably phenyl or substituted phenyl. R₂ and R₃ together may form the same groups as R₁ and are preferably phenyl or substituted phenyl. Where substituents are present they may be methyl, ethyl, propyl or butyl, including t-butyl substituted, or may be methoxy, ethoxy, propoxy or butoxy including t-butoxy substituted. Particular compounds include

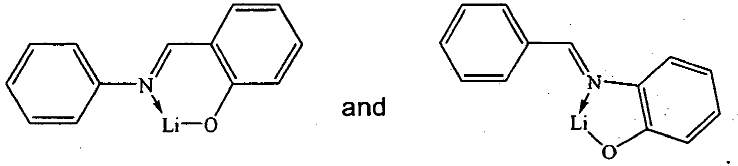

Lithium compounds whose formulae are set out above are believed from mass spectrometry (MS) measurements to be capable of forming cluster compounds or oligomers in which 2 to 8 molecules of formula as set out above are associated e.g. in the form of trimeric, tetrameric, hexameric or octomeric oligomers. It is believed that such lithium compounds may in some embodiments associate in trimeric units having a core structure which has alternating Li and O atoms in a 6-membered ring, and that these trimeric units may further associate in pairs. The existence of such structures in lithium quinolate has been detected by crystallography, see Begley et al., Hexakis(µ-quinolin-8-olato)hexalithium (I): a centrosymmetric doubly stacked trimer, Acta Cryst. (2006), E62, m1200-m1202. It is also believed that formation of oligomeric structures of this type imparts a greater covalent character to the Li-O bonds which may be responsible for the volatility of many of the compounds of the invention which enables them to be deposited at relatively low temperatures by vacuum sublimation. However, other structures may also be possible e.g. cubic structures.

### Hole blocking material

The devices according to the present invention may also comprise a hole blocking material (HBM). A HBM refers to a material or unit which, if coated adjacent to a hole transporting layer in a multilayer structure, prevents the holes flowing through. Usually it has a lower HOMO as compared to the HOMO level of the hole transport material in the adjacent hole transporting layer.

Hole-blocking layers are frequently inserted between the light-emitting layer and the electron-transport layer in devices comprising phosphorescent emitters.

Suitable hole-blocking materials are metal complexes (US 2003/0068528), such as, for example, bis(2-methyl-8-quinolinolato)(4-phenylphenolato)aluminium(III) (BAIQ). Fac-tris(1-phenylpyrazolato-N,C2)iridium(III) (Ir(ppz)₃) is likewise used for this purpose (US 2003/0175553 A1). Phenanthroline derivatives, such as, for example, 2,9-dimethyl-4,7-diphenyl-1,10-phenanthroline (= bathocuproin, BCP), or phthalimides, such as, for example, 2,3,5,6-tetramethylphenyl-1,4-(bisphthalimide) (TMPP), are likewise employed.

Suitable hole-blocking materials are described in WO 00/70655 A2, WO 01/41512 and WO 01/93642 A1.

### Electron Blocking material

The devices according to the present invention may also comprise an electron blocking material (EBM). An EBM refers to a material or unit which, if coated adjacent to an electron transporting layer in a multilayer structure, prevents the electron flowing through. Usually it has a higher LUMO as compared to the LUMO of the electron transport materialin the adjacent electron transporting layer.

Transition-metal complexes, such as, for example, Ir(ppz)₃ (US 2003/0175553) can be employed as materials for an electron-blocking layer.

### Exciton blocking material

The devices according to the present invention may also comprise an exciton blocking material (ExBM). The ExBM refers to a material or unit which, if coated adjacent to an emssive layer in a multilayer structure, prevents the exciton diffuse through. ExBM should have either a higher triplet level or singlet level as compared to the corresponding level of the emissive layer or other adjacent layer.

### Dyes

The devices according to the present invention may also comprise a dye. A dye can generally be described as an inorgamic or organic substance that absobs light and therefore appears colored.

Preferred dyes are selected from the group of acridines, anthraquinones, arylmethanes, diarylmethanes, triarylmethanes, azo-based dyes, cyanines, diazonium-based dyes, nitro-based dyes, nitroso-based dyes, phthalocyanine dyes, quinone-imines, azin-based dyes, eurhodines, safranines, indulines, indamins, indophenoles, oxazines, oxazones, thiazines, thiazoles, xanthenes, fluorenes, pyronines, fluorones, rhodamines, and derivates thereof.

### Photoabsorption material

The devices according to the present invention may also comprise a photoabsorbing material. A Photoabsorption material is a dye as mentioned above

### Metal complexes

The devices according to the present invention may also comprise a metal complex The metal of ths complex is preferably slected from transition metals, rare earth elements, lanthanides and actinides is also subject of this invention. Preferably the metal is selected from Ir, Ru, Os, Eu, Au, Pt, Cu, Zn, Mo, W, Rh, Pd, or Ag.

### Cathode

The cathode on which there is the layer of electron injection material is in some embodiments a low work function metal. The metal electrode may consist of a plurality of metal layers; for example a higher work function metal such as aluminium deposited on the substrate and a lower work function metal such as calcium or lithium or casesium deposited on the higher work function metal. The work function of some metals are listed below in Table 1

**Table 1**

| Metal | Work Function eV* |
|---|---|
| Li | 2.9 |
| Na | 2.4 |
| K | 2.3 |
| Cs | 1.9 |
| Ba | 2.5 |
| Ca | 2.9 |
| Nb | 2.3 |
| Zr | 4.05 |
| Mg | 3.66 |
| Al | 4.2 |
| Cu | 4.6 |
| Ag | 4.64 |
| Zn | 3.6 |
| Sc | 3.5 |

| | |
|---|---|
| * Handbook of Chemistry and Physics | |

In many embodiments, aluminium is used as the cathode either on its own or alloyed with elements such as magnesium or silver, although in some embodiments other cathode materials e.g. calcium, may be employed. In an embodiment the cathode may comprise a first layer of alloy e.g. Li-Ag, Mg-Ag or Al-Mg closer to the electron injection or electron transport layer and a second layer of pure aluminium further from the electron injection or electron transport layer. In further embodiments the cathode material may be Ag or MgAg or Mgln. Cathode materials may also be on transparent plate materials which may be of glass or may be of plastics which may be rigid or flexible and may be optically transparent As regards plastics substrates, rigid or flexible transparent plastics materials may be used, preferably materials which are dimensionally stable, impermeable to water (including water vapour) of relatively high glass transition temperature (Tg). PEN is a preferred material, other materials that may be used including PES, PEEK and PET. The plastics may be coated with a conductive film and may also have a barrier coating to improve resistance to moisture which may be encountered under working conditions e.g. atmospheric moisture. In yet further embodiments the cathode may be crystalline, polycrystalline, continuous grain or amorphous silicon which may be n-doped.

### Substrate

The substrate may be rigid or flexible. It may be transparent, translucent, opaque or reflective. The materials used can be glass, plastic, ceramic or metal foils, where plastic and metal foils are preferably used for flexible substrates. However, semiconductor materials, such as, for example, silicone wafers or printed circuit board (PCB) materials, can also be employed in order to simplify the generation of conductor tracks. Other substrates can also be employed.

The glass used can be, for example, soda-lime glass, Ba- or Sr-containing glass, lead glass, aluminium silicate glass, borosilicate glass, Ba borosilicate glass or quartz.

Plastic plates can consist, for example, of polycarbonate resin, acrylic resin, vinyl chloride resin, polyethylene terephthalate resin, polyimide resin, polyester resin, epoxy resin, phenolic resin, silicone resin, fluorine resin, polyether sulfide resin or polysulfone resin.

For transparent films, use is made, for example, of polyethylene, ethylene-vinyl acetate copolymers, ethylene-vinyl alcohol copolymers, polypropylene, polystyrene, polymethyl methacrylate, PVC, polyvinyl alcohol, polyvinylbutyral, nylon, polyether ether ketone, polysulfone, polyether sulfone, tetrafluoroethylene-perfluoroalkyl vinyl ether copolymers, polyvinyl fluoride, tetrafluoroethylene-ethylene copolymers, tetrafluoroethylene-hexafluoropropylene copolymers, polychlorotrifluoroethylene, polyvinylidene fluoride, polyester, polycarbonate, polyurethanes, polyimide or polyether imide.

The substrate is provided with a hydrophobic layer. The substrates are preferably transparent.

Other materials than those mentioned here can also be used. Suitable materials are known to the person skilled in the art.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

It will be appreciated that many of the features described above, particularly of the preferred embodiments, are inventive in their own right and not just as part of an embodiment of the present invention. Independent protection may be sought for these features in addition to or alternative to any invention presently claimed.

The teaching as disclosed here can be abstracted und combined with other examples disclosed.

Other features of the invention will become apparent in the course of the following descriptions of exemplary embodiments, which are given for illustration of the invention and are not intended to be limiting thereof.

### Working Examples

### Example 1

### Preparation of Zirconium tetrakis(8-hydroxyquinolinate)- [Zrq₄-A]

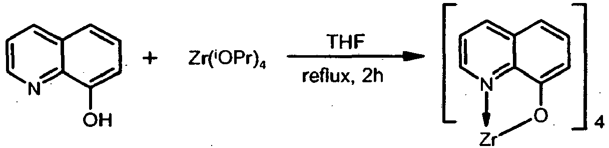

8-Hydroxyquinoline, 99+% (Aldrich) (100 g; 0.69 mol) is dissolved in tetrahydrofuran, 99+% (ACS reagent) (400 ml). To the magnetically stirred solution is added zirconium isopropoxide (66.8 g; 0.17 mol) in tetrahydrofuran (175 ml), all at once. A yellow precipitate forms immediately. The reaction mixture is magnetically stirred and refluxed under nitrogen for 2 hours. After cooling the reaction mixture in the refrigerator the product is filtered off under suction, washed with fresh tetrahydrofuran and dried under vacuum at 80°C for 10 hours. Yield 101 g (88%). M.p 388°C (DSC, onset). The product is sublimed to give a sublimation yield of 91%. Overall yield is 81%.

### Example 2

### Preparation of Zirconium tetrakis(8-hydroxyquinolinate)-[Zrq₄-B]

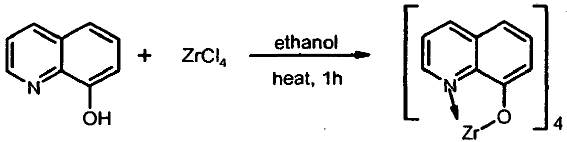

Ethanol is dried over potassium hydroxide and distilled before use. To a solution of 8-hydroxyquinoline (100.0 g; 0.69 mol) in ethanol, 95% (700 ml) is carefully added zirconium (IV) chloride (40.2 g; 0.17 mol) in ethanol (200 ml) at 10°C (The solution is cooled in an ice-water bath). After 10 minutes, the solution is warmed to 50°C and piperidine (75 ml; 0.76 mol) is slowly added, during which time a yellow precipitate separates out. The suspension is heated at about 60°C for 2 h, and allowed to cool to room temperature. The precipitate is collected by suction filtration on a Buchner funnel, washed thoroughly with ethanol, tetrahydrofuran and finally with diethyl ether. The product is dried under vacuum at 80°C. Crude yield 106.5 g (93%).

Further purification of the product (65 g) is performed by Soxhlet extraction (65 g) with 1,4-dioxane for 24 h. Concentration of the extract yieldes a yellow precipitate which is collected on a Buchner funnel and washed with ethanol, (95%; 100 ml). The product is dried under vacuum at 80°C for 8h. Yield, 50 g (77%). M.p., 388°C (DSC, onset). The product is further purified by sublimation to give a sublimed yield of 92%. Overall yield is 66%.

### Example 3

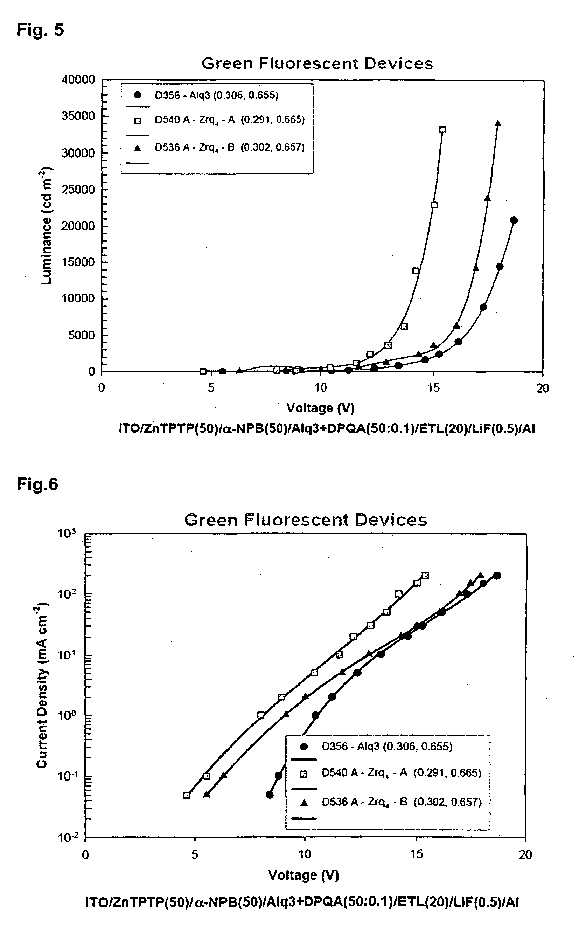

Devices with green emission are formed as follows. A pre-etched ITO coated glass piece (10 x 10 cm²) is used. The device is fabricated by sequentially forming layers on the ITO, by vacuum evaporation using a Solciet Machine, ULVAC Ltd. Chigacki, Japan. The active area of each pixel is 3 mm by 3 mm. The coated electrodes are encapsulated in an inert atmosphere (nitrogen) with UV-curable adhesive using a glass back plate. Electroluminescence studies are performed with the ITO electrode is always connected to the positive terminal. The current density vs. voltage studies are carried out on a computer controlled Keithly 2400 source meter. By the method described above devices consisting of an anode layer, buffer layer, hole transport layer, electroluminescent layer (doped material), electron transport layer, electron injection layer and cathode layer are obtained. The layer composition is described in Figs. 5 to 8 and film thicknesses being in nm. The CIE colour coordinates and other characteristics are as illustrated. It will be noted that significantly better performance is obtained with the A-form of zirconium quinolate than with the B-form.

### Example 4

Diffraction data are collected at 150 K as ω scans on a Bruker SMART1000 CCD area detector diffractometer, equipped with an Oxford Cryosystems open-flow nitrogen gas cooler (Cosier, J. & Glazer, A.M. (1986). J. Appl. Crystallogr. 19, 105-107) and graphite-monochromated Mo-Kα radiation (A = 0.71073 A). The structure is solved by direct methods using SHELXS97 (Sheldrick, G. M. (2008). Acta Crystallogr., Sect. A. 64, 112-122), developed by iterative cycles of least-squares refinement and difference Fourier synthesis, and refined by full-matrix least-squares on F² using SHELXL97 (Sheldrick, G. M. (2008). Acta Crystallogr., Sect. A. 64, 112-122). All non-hydrogen atoms are refined anisotropically. Hydrogen atoms are introduced at geometrically calculated positions and refined using a riding model with Uᵢₛₒ(H) = 1.2U_{eq}(parent atom). The following unit cell parameters are obtained: space group P21/c, a = 11.22 Å, b = 14.67 Å, c = 17.21 Å, α = 90°, β = 94.816°, γ = 90°, and unit cell volumen V = 2822.7 Å³.

## Claims

1. Zirconium quinolate having a monoclinic crystal structure.

2. Zirconium quinolate according to claim 1, charcterized in that the space group is P21/c.

3. Zirconium quinolate according to claim 1 or 2, **characterized in that** the unit cell dimensions are a = 11.2 ± 0.4 Å, b = 14.7 ± 0.4 Å, c = 17.2 ± 0.4 Å, α = 90°, β = 95° ± 1°, γ = 90°, and unit cell volumen V = 2823 ± 5 Å³.

4. Zirconium quinolate of one or more of the claims 1 to 3, **characterized in that** the unit cell dimensions are a = 11.22 Å, b = 14.67 Å, c = 17.21 Å, α = 90°, β = 94.816°, γ = 90°, and unit cell volumen V = 2822.7 Å³

5. Zicronium quinolate of one or more of the claims 1 to 4 **characterized in that** the purity is greater than or equal to 80%, preferably greater than or equal to 85%, particularly preferably greater than or equal to 90%, and very particularly preferably greater than or equal to 95%.

6. A method of making zirconium quinolate in monoclinic form, which comprises reacting a zirconium alkoxide with 8-hydroxyquinoline in a solvent comprising tetrahydrofuran, recovering the zirconium quinolate and purifying it by sublimation.

7. The method of claim 6, **characterized in that** the zirconium alkoxide is zirconium isopropoxide.

8. An optical light emitting device having a first electrode, a layer comprising monoclinic zirconium quinolate and a second electrode.

9. A device according to claim 8, having one or more of the following features:
(a) a hole injection layer comprising a porphyrinic compound;
(b) a hole injection layer comprising ZnTpTP; 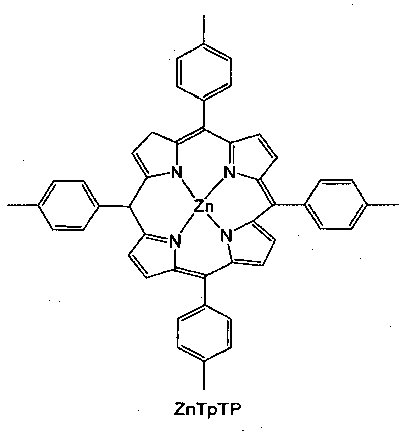
(c) a hole transport layer comprising an aromatic amine selected from 4,4'-bis(N-(3-methylphenyl)-N-phenylamino)biphenyl (NPD), TPD 232, 4,4',4"-tris[3-methylphenyl)phenylamino]-triphenylamine (MTDATA), HIL1, HIL2, HIL3, and CHATP

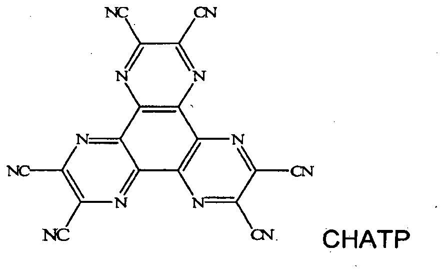

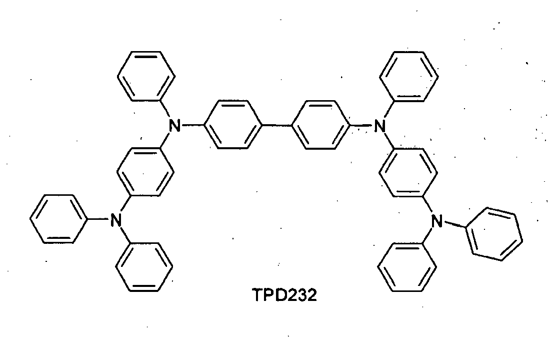

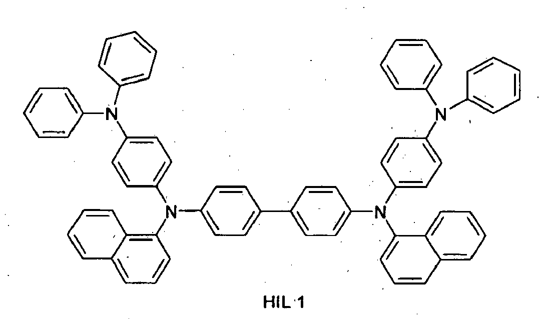

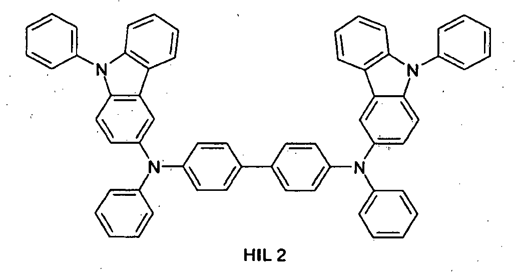

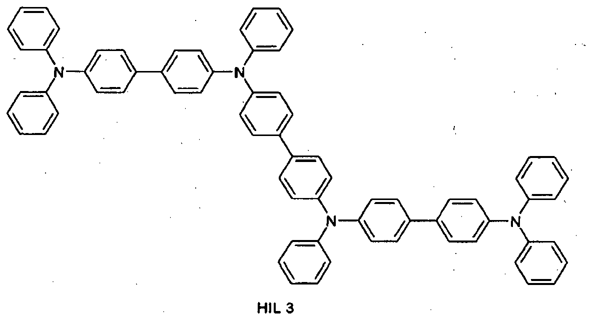

10. The device according to claim 8 or 9, having one or more of the following features
(a) a hole transport layer comprising an aromatic tertiary amine;
(b) a hole transport layer comprising any of 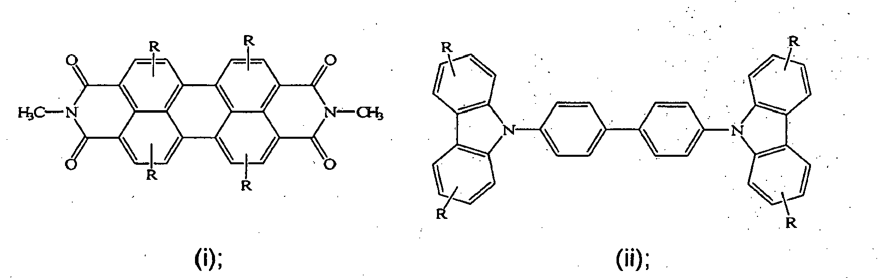 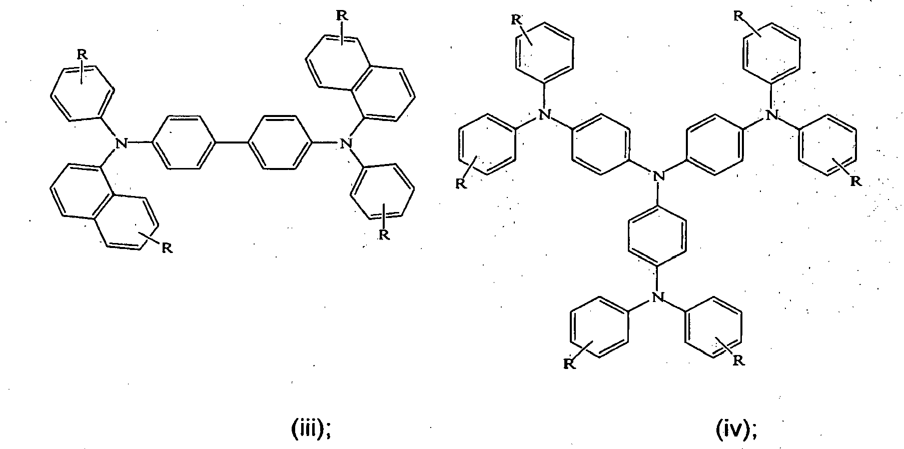 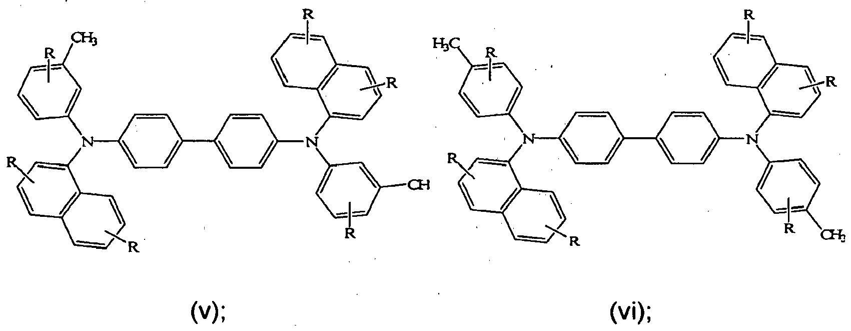 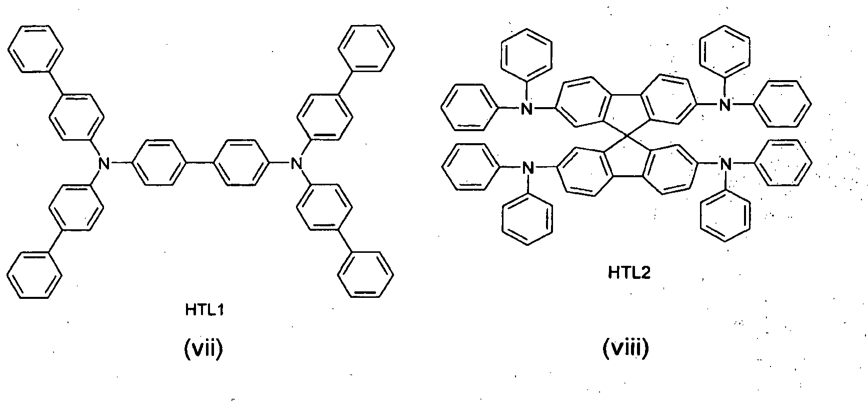 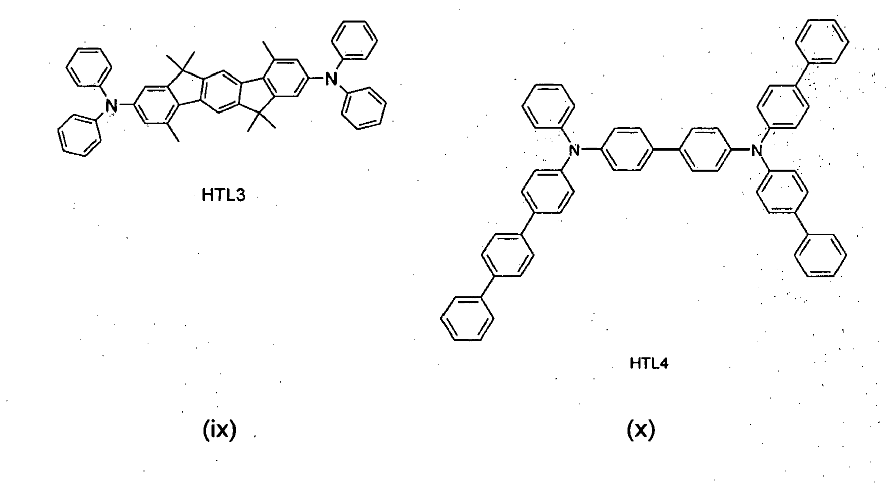 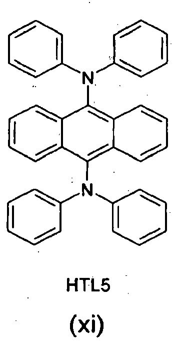 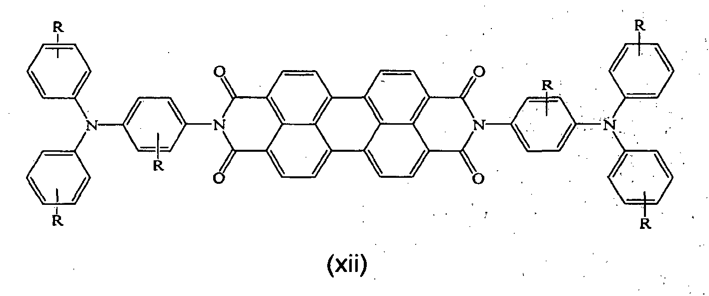 wherein
the groups R in any of the formulae in (i) to (xii) can be the same or different and are selected from hydrogen; substituted and unsubstituted aliphatic groups; substituted and unsubstituted aromatic, heterocyclic and polycyclic ring structures; halogens; and th iophenylg roups;
and
wherein
in formula (i) the methyl groups may be replaced by C₁ to C₄ alkyl or monocyclic or polyclic aryl or heteroraryl which may be further substituted e.g. with alkyl, aryl or arylamino.
(a) the hole transport materials comprises a compound of formula 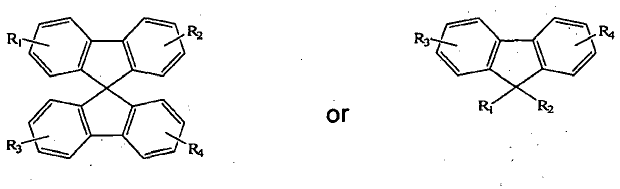 wherein the groups R₁ to R₄ when appearing in either of the above formulae can be the same or different and are selected from hydrogen; substituted and unsubstituted aliphatic groups; substituted and unsubstituted aromatic, heterocyclic and polycyclic ring structures; halogens; and thiophenyl groups;
(d) the hole transport layer comprises α-NPB

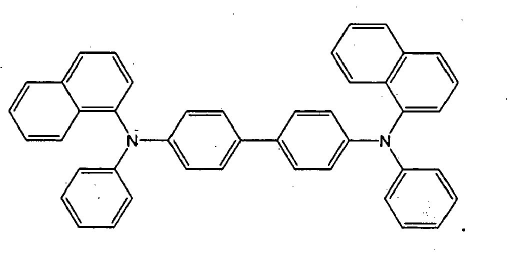

11. The device according to one or more of the claims 8 to 10, **characterized in that** the electroluminescent layer has one or more of the following features:
(a) it comprises a metal or metalloid complex;
(b) it comprises zirconium quinolate as host material doped with a dopant;
(c) it comprises monoclinic zirconium quinolate;
(d) it comprises aluminium quinolate as host material doped with a dopant;
(e) it comprises an iridium, ruthenium, osmium, rhodium, palladium or platinum complex, a boron complex or a rare earth complex;
(f) it comprises an aromatic tertiary amine as host material doped with a dopant;
(g) it comprises as a host material selected from carbazols, ketones, phosphinoxides, sufoxides, bipolar hosts, and oligoarylenes selected from anthracenes, dinaphthyl anthracenes, benzanthracene anthracenes, tetraphenylspirobifluorenes.
(h) it comprises a light-emitting conjugated polymer or copolymer or a dendrimer;
(i) it comprises monoclinic zirconium quinolate doped with a dopant;
(j) the dopant is selected from phosphorescent emitters, diphenylacridine, coumarins, perylene, quinolates, porphoryin, porphines, pyrazalones and derivatives thereof, aryl amines preferably indenofluorene monoamines and -diamines, benzofluorene monoamines and -diamines and dibenzoindenofluorene monoamines and -diamines;
(k) there is up to 10 mole percent fluorescent material, based on moles of organo metallic complex;
(l) there is up to 1 mole percent fluorescent material, based on moles of organo metallic complex;
(m) there is less than 10⁻³ mole percent fluorescent material, based on moles of organo metallic complex.

12. The device according to one or more of the claims 8 to 11, **characterized in that** the electron transport layer comprises monoclinic zirconium quinolate or a composition comprising monoclinic zirconium quinolate and at least one further electron transport material preferably selected from benzimidazoles and quinolates of Li, Al, Ga, Mg, Zn, and Be, particularly preferably lithium quinolate.

13. The device according to one or more of the claims 8 to 12, having an electron injection layer based on metal quinolates, preferably quinolates of Li, Al, Ga, Mg, Zn, and Be or an inorganic lithium compound or a lithium complex.

14. The device according to one or more of the claims 8 to 13, which is a flat panel display.

15. The device according to claim 14, which is a passive matrix display.

16. The device according to claim 14 which is an active matrix display.

17. An imaging member for creation of an electrostatic latent image containing monoclinic zirconium quinolate.

18. A lamp containing electroluminescent material and monoclinic zirconium quinolate as a host or as an electron transport material.

## Patentansprüche

1. Zirconiumchinolinat mit monokliner Kristallstruktur.

2. Zirconiumchinolinat nach Anspruch 1, **dadurch gekennzeichnet, dass** es sich bei der Raumgruppe um P21/c handelt.

3. Zirconiumchinolinat nach Anspruch 1 oder 2, **dadurch gekennzeichnet, dass** die Abmessungen der Elementarzelle a = 11,2 ± 0,4 Å, b = 14,7 ± 0,4 Å, c = 17,2 ± 0,4 Å, α = 90°, β = 95°± 1°, γ = 90° betragen und das Volumen der Elementarzelle V = 2823 ± 5 Å³ ist.

4. Zirconiumchinolinat eines oder mehrerer der Ansprüche 1 bis 3, **dadurch gekennzeichnet, dass** die Abmessungen der Elementarzelle a = 11,22 A, b = 14,67 Å, c = 17,21 Å, α = 90°, β = 94,816°, γ = 90° betragen und Volumen der Elementarzelle V = 2822,7 Å³ ist.

5. Zirconiumchinolinat eines oder mehrerer der Ansprüche 1 bis 4, **dadurch gekennzeichnet, dass** die Reinheit größer als oder gleich 80%, bevorzugt größer als oder gleich 85%, besonders bevorzugt größer als oder gleich 90% und ganz besonders bevorzugt größer als oder gleich 95% ist.

6. Verfahren zur Herstellung von Zirconiumchinolinat in monokliner Form, bei dem man ein Zirconiumalkoholat in einem Tetrahydrofuran enthaltenden Lösungsmittel mit 8-Hydroxychinolin umsetzt, das Zirconiumchinolinat gewinnt und es durch Sublimation reinigt.

7. Verfahren des Anspruches 6, **dadurch gekennzeichnet, dass** es sich bei dem Zirconiumalkoholat um Zirconiumisopropanolat handelt.

8. Optische Lichtemittervorrichtung mit einer ersten Elektrode, einer monoklines Zirconiumchinolinat enthaltenden Schicht und einer zweiten Elektrode.

9. Vorrichtung nach Anspruch 8, mit einem oder mehreren der folgenden Merkmale:
(a) eine Lochinjektionsschicht, die eine Porphyrinverbindung enthält;
(b) eine ZnTpTP enthaltende Lochinjektionsschicht; 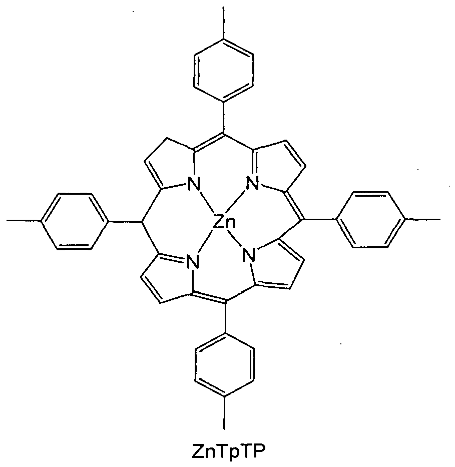
(c) eine Lochtransportschicht, die ein aus 4,4'-Bis(N-(3-methylphenyl)-N-phenylamoino)biphenyl (NPD), TPD 232, 4,4',4"-Tris(3-methylphenyl)phenylamoino)triphenylamin (MTDATA), HIL1, HIL2, HIL3 und CHATP ausgewähltes aromatisches Amin enthält

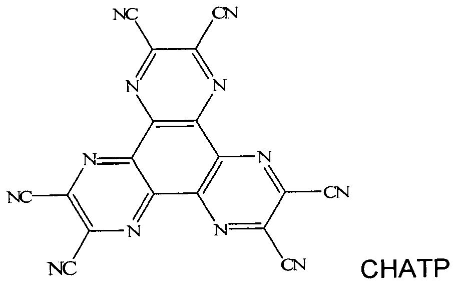

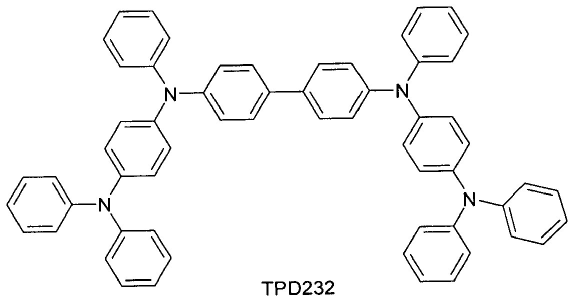

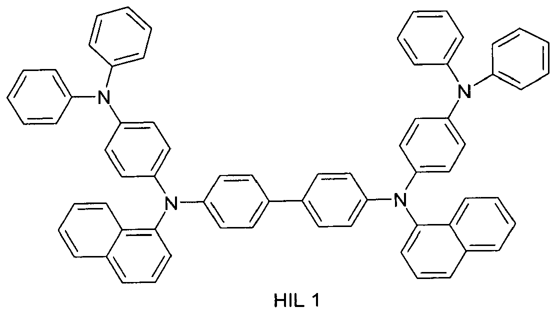

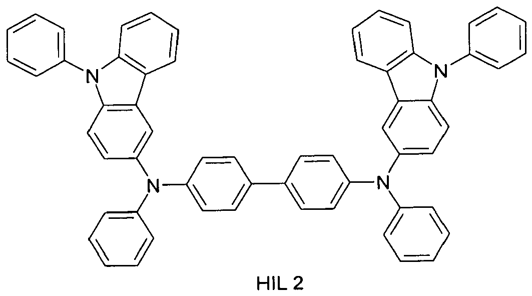

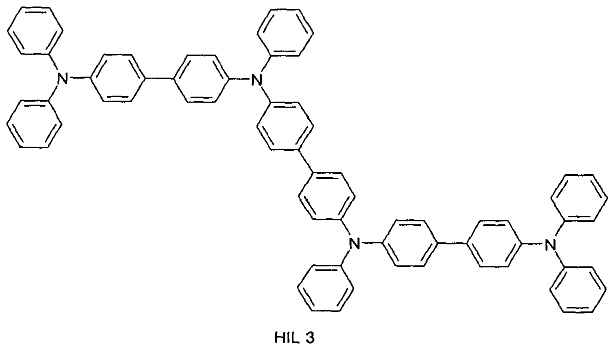

10. Vorrichtung nach Anspruch 8 oder 9, mit einem oder mehreren der folgenden Merkmale
(a) eine Lochtransportschicht, die ein aromatisches tertiäres Amin enthält;
(b) eine Lochtransportschicht, die ein beliebiges von 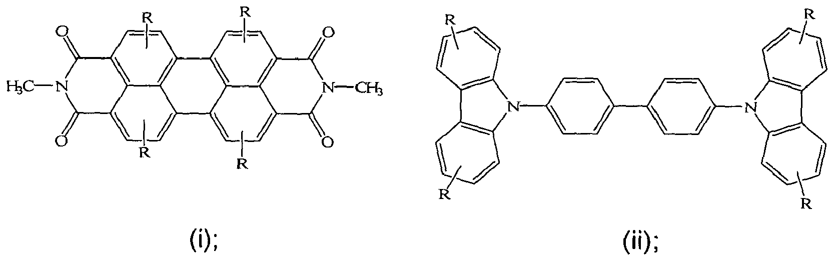 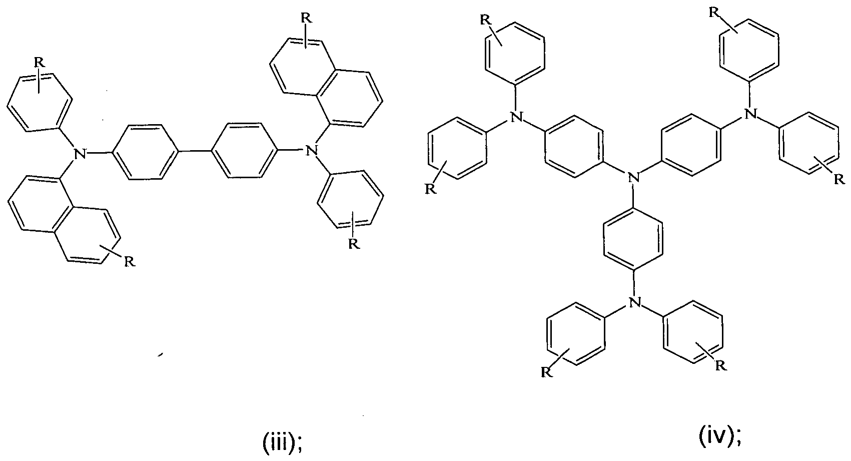 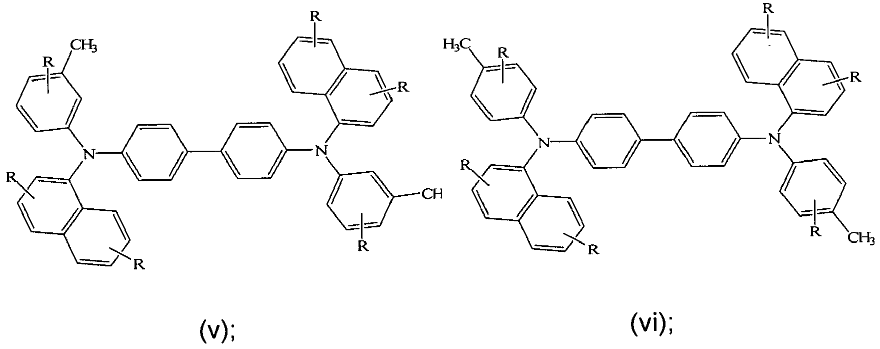 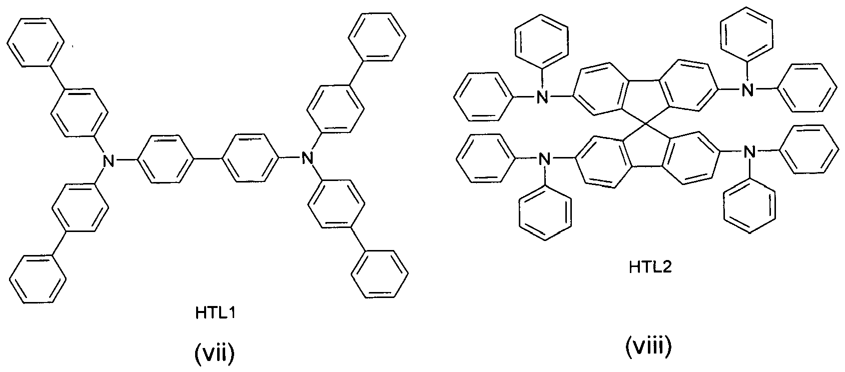 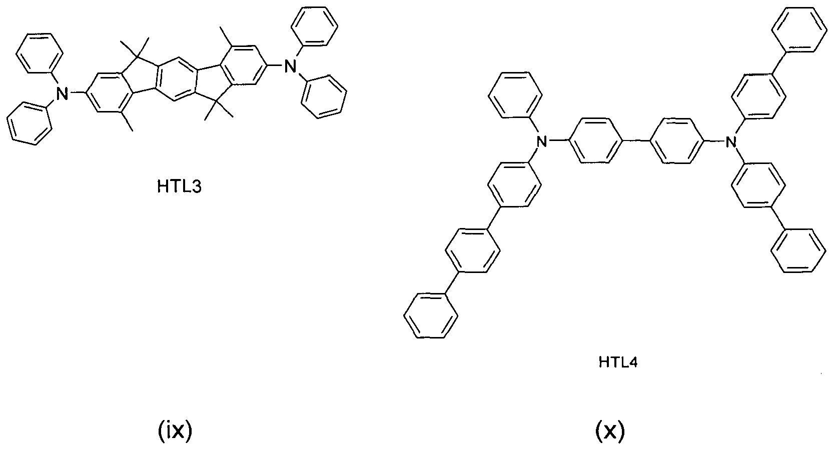 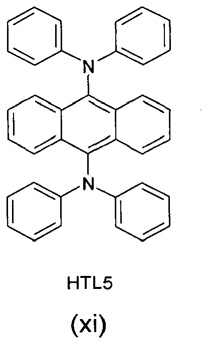 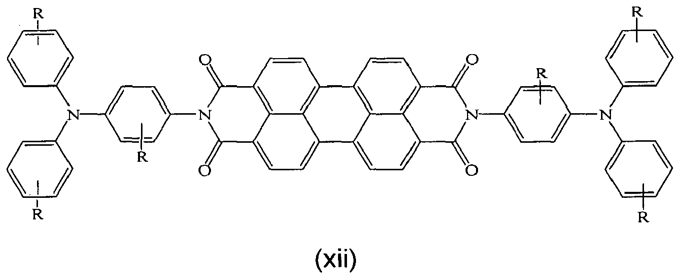 enthält, in denen
die Gruppen R in beliebigen der Formeln in (i) bis (xii) gleich oder verschieden sein können und ausgewählt sind aus Wasserstoff; substituierten und unsubstituierten aliphatischen Gruppen; substituierten und unsubstituierten aromatischen, heterocyclischen und polycyclischen Ringstrukturen; Halogenen und Thiophenylgruppen;
und
in denen
in Formel (i) die Methylgruppen durch C₁- bis C₄-Alkyl oder monocyclisches oder polyclisches Aryl oder Heteroaryl ersetzt sein können, die weiter substituiert sein können, z.B. mit Alkyl, Aryl oder Arylamino.
(c) das Lochtransportmaterial eine Verbindung der Formel 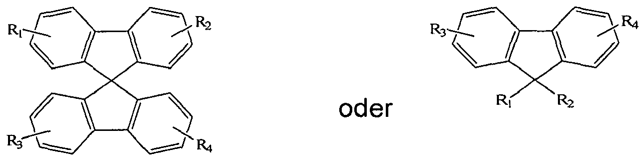 enthält, in denen
die Gruppen R₁ bis R₄ bei Auftreten in einer der beiden obigen Formeln gleich oder verschieden sein können und ausgewählt sind aus Wasserstoff; substituierten und unsubstituierten aliphatischen Gruppen; substituierten und unsubstituierten aromatischen, heterocyclischen und polycyclischen Ringstrukturen; Halogenen und Thiophenylgruppen;
(d) die Lochtransportschicht α-NPB 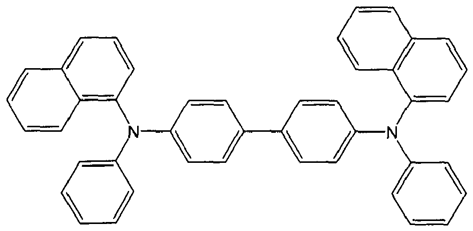 enthält.

11. Vorrichtung nach einem oder mehreren der Ansprüche 8 bis 10, **dadurch gekennzeichnet, dass** die Elektrolumineszenzschicht eines oder mehrere der folgenden Merkmale aufweist:
(a) sie enthält einen Metall- oder Metalloidkomplex;
(b) sie enthält mit einem Dotierstoff dotiertes Zirconiumchinolinat als Host-Material;
(c) sie enthält monoklines Zirconiumchinolinat;
(d) sie enthält mit einem Dotierstoff dotiertes Aluminiumchinolat als Host-Material;
(e) sie enthält einen Iridium-, Ruthenium-, Osmium-, Rhodium-, Palladium- oder Platinkomplex, einen Borkomplex oder einen Seltenerdkomplex;
(f) sie enthält ein mit einem Dotierstoff dotiertes aromatisches tertiäres Amin als Host-Material;
(g) sie enthält ein Host-Material ausgewählt aus Carbazolen, Ketonen, Phosphinoxiden, Sulfoxiden, bipolaren Hosts und Oligoarylenen, ausgewählt aus Anthracenen, Dinaphthylanthracenen, Benzanthracenanthracenen, Tetraphenylspirobifluorenen;
(h) sie enthält ein lichtemittierendes konjugiertes Polymer oder Copolymer oder ein Dendrimer;
(i) sie enthält mit einem Dotierstoff dotiertes monoklines Zirconiumchinolinat;
(j) das Dotierstoff ist ausgewählt aus phosphoreszierenden Emittern, Diphenylacridin, Cumarinen, Perylen, Chinolaten, Porphyrine, Porphinen, Pyrazalonen und deren Derivaten, Arylaminen, vorzugsweise Indenofluoren-monoaminen und -diaminen, Benzofluoren-monoaminen und -diaminen und Dibenzoindenofluoren-monoaminen und -diaminen;
(k) es liegen bis zu 10 Molprozent fluoreszierendes Material, bezogen auf Mole metallorganischer Komplex, vor;
(l) es liegt bis zu 1 Molprozent fluoreszierendes Material, bezogen auf Mole metallorganischer Komplex, vor;
(m) es liegen weniger als 10⁻³ Molprozent fluoreszierendes Material, bezogen auf Mole metallorganischer Komplex, vor.

12. Vorrichtung nach einem oder mehreren der Ansprüche 8 bis 11, **dadurch gekennzeichnet, dass** die Elektronentransportschicht monoklines Zirconiumchinolinat oder eine monoklines Zirconiumchinolinat enthaltende Zusammensetzung und mindestens ein weiteres Elektronentransportmaterial, vorzugsweise ausgewählt aus Benzimidazolen und Chinolaten des Li, Al, Ga, Mg, Zn und Be, besonders bevorzugt Lithiumchinolat, enthält.

13. Vorrichtung nach einem oder mehreren der Ansprüche 8 bis 12, mit einer Elektroneninjektionsschicht auf der Grundlage von Metallchinolaten, vorzugsweise Chinolaten des Li, Al, Ga, Mg, Zn und Be, oder einer anorganischen Lithiumverbindung oder eines Lithiumkomplexes.

14. Vorrichtung nach einem oder mehreren der Ansprüche 8 bis 13, bei der es sich um eine Flachbildschirmanzeige handelt.

15. Vorrichtung nach Anspruch 14, bei der es sich um eine Passivmatrix-Anzeige handelt.

16. Vorrichtung nach Anspruch 14, bei der es sich um eine Aktivmatrix-Anzeige handelt.

17. Bilderzeugendes Element zur Erzeugung eines elektrostatischen latenten Bildes enthaltend monoklines Zirconiumchinolinat.

18. Leuchte enthaltend Elektrolumineszenzmaterial und monoklines Zirconiumchinolinat als Host oder als ein Elektronentransportmaterial.

## Revendications

1. Quinolate de zirconium présentant une structure cristalline monoclinique.

2. Quinolate de zirconium selon la revendication 1, **caractérisé en ce que** le groupe d'espaceur est P21/c.

3. Quinolate de zirconium selon la revendication 1 ou 2, **caractérisé en ce que** les dimensions de cellule unitaire sont a = 11,2 ± 0,4 Å, b = 14,7 ± 0,4 Å, c = 17,2 ± 0,4 Å, α = 90°, β = 95°± 1°, γ = 90 et volume de cellule unitaire V = 2823 ± 5 Å³.

4. Quinolate de zirconium selon une ou plusieurs des revendications 1 à 3, **caractérisé en ce que** les dimensions de cellule unitaire sont a = 11,22 Å, b = 14,67 Å, c = 17,21 Å, α = 90°, β = 94,816°, γ = 90 et volume de cellule unitaire V = 2822,7 Å³

5. Quinolate de zirconium selon une ou plusieurs des revendications 1 à 4, **caractérisé en ce que** la pureté est supérieure ou égale à 80%, de façon préférable supérieure ou égale à 85%, de façon particulièrement préférable supérieure ou égale à 90% et de façon très particulièrement préférable supérieure ou égale à 95%.

6. Procédé de fabrication de quinolate de zirconium sous forme monoclinique, lequel comprend le fait de faire réagir un alcoxyde de zirconium avec du 8-hydroxyquinoline dans un solvant comprenant du tétrahydrofurane, le fait de récupérer le quinolate de zirconium et le fait de le purifier par sublimation.

7. Procédé selon la revendication 6, **caractérisé en ce que** l'alcoxyde de zirconium est de l'isopropoxyde de zirconium.

8. Dispositif optique émetteur de lumière comportant une première électrode, une couche comprenant du quinolate de zirconium monoclinique et une seconde électrode.

9. Dispositif selon la revendication 8, comportant une ou plusieurs des caractéristiques qui suivent :
(a) une couche d' injection de trous comprenant un composé porphyrinique ;
(b) une couche d'injection de trous comprenant du ZnTpTP ; 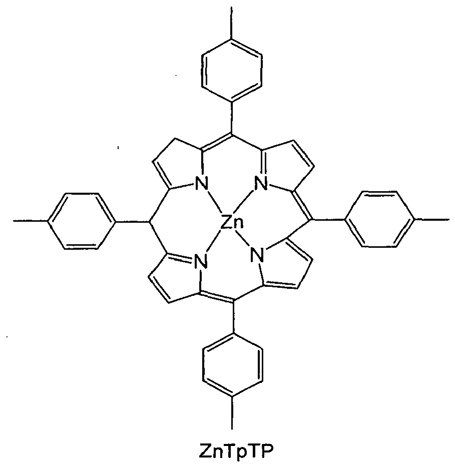
(c) une couche de transport de trous comprenant un amine aromatique choisi parmi 4,4'-bis(N-(3-méthylphényl)-N-phényl-amino)biphényle (NPD), TPD 232, 4,4',4"-tris[3-méthylphényl)-phénylamino]-triphényamine (MTDATA), HIL1, HIL2, HIL3 et CHATP

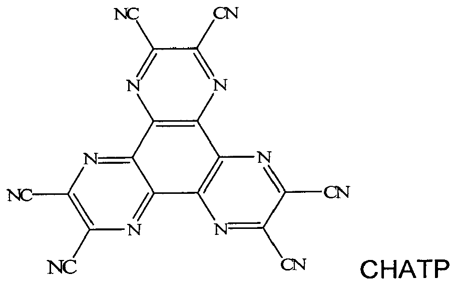

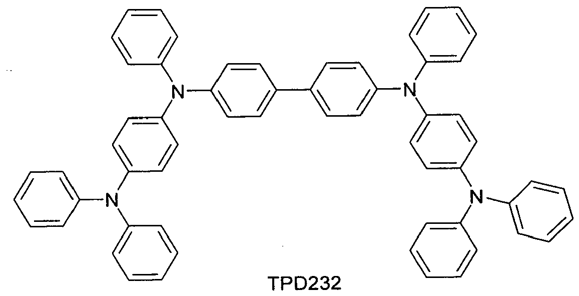

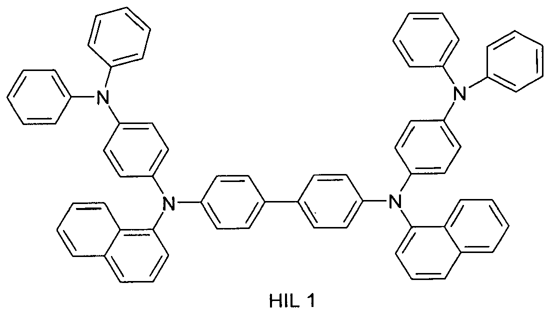

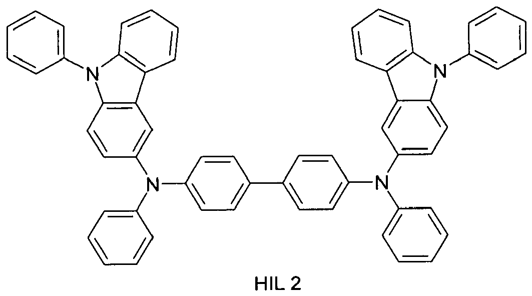

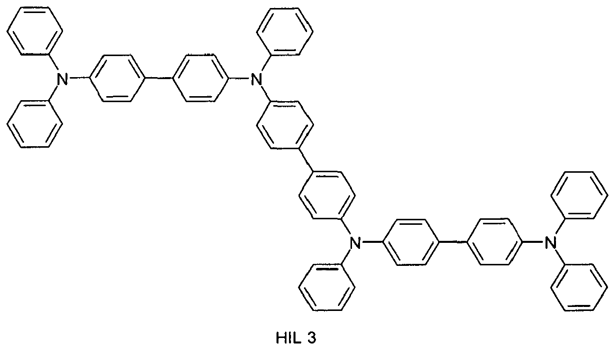

10. Dispositif selon la revendication 8 ou 9, comportant une ou plusieurs des caractéristiques qui suivent :
(a) une couche de transport de trous comprenant un amine tertiaire aromatique ;
(b) une couche de transport de trous comprenant un corps quelconque selon les formules qui suivent : 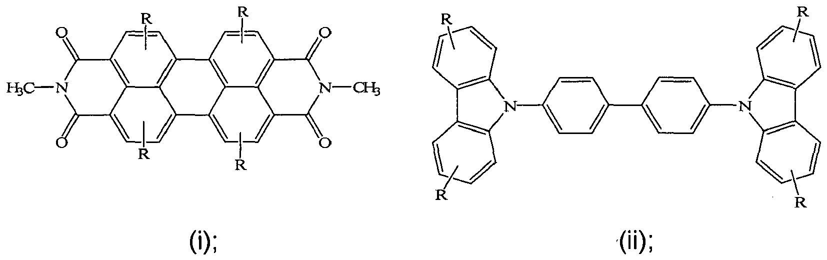 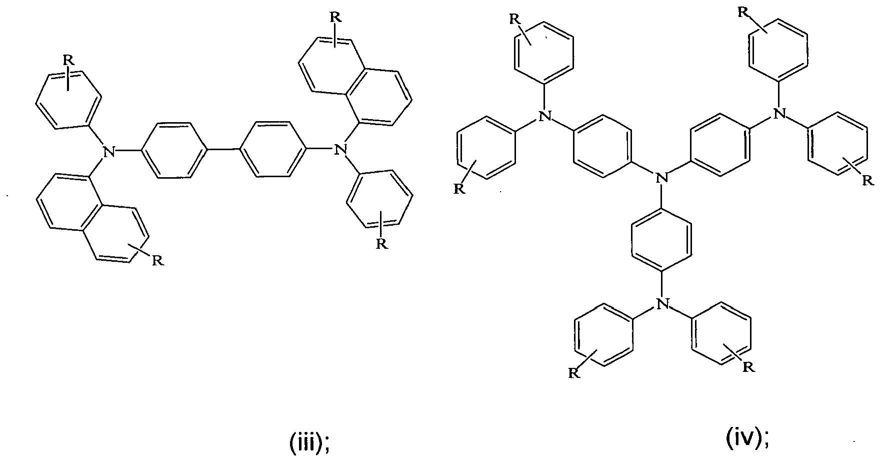 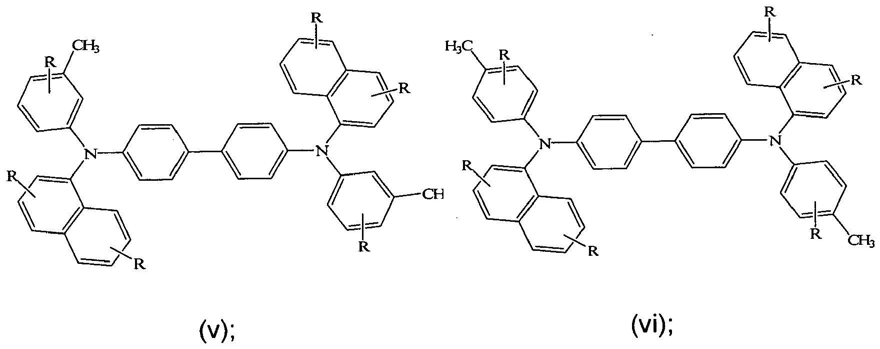 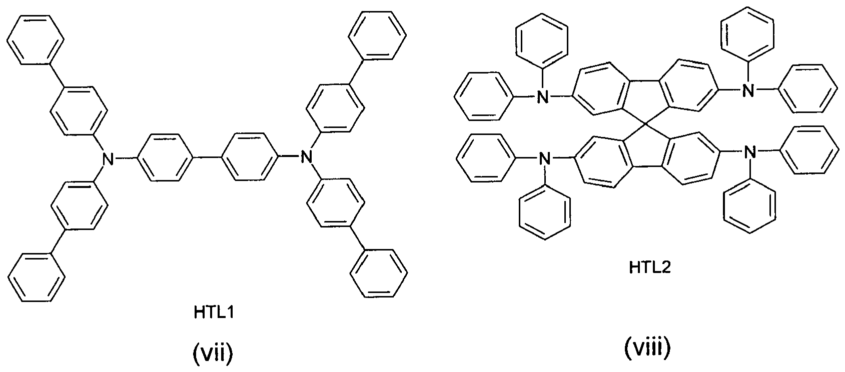 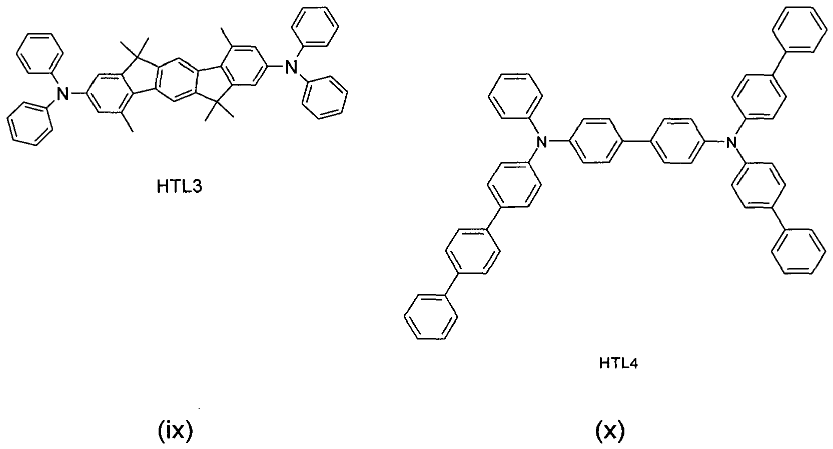 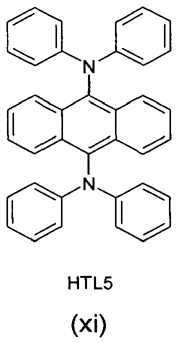 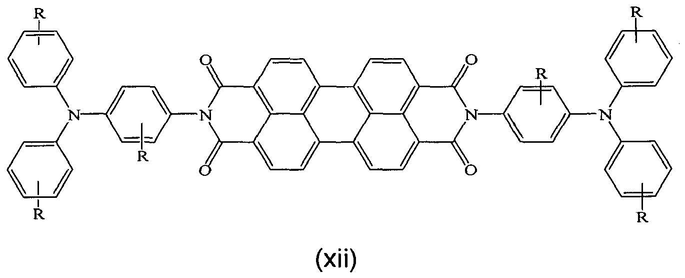 dans lesquelles :
les groupes R dans n'importe laquelle des formules (i) à (xii) peuvent être les mêmes ou différents et sont choisis parmi hydrogène ; des groupes aliphatiques substitués et non substitués ; des structures de cycle aromatiques, hétérocycliques et polycycliques substituées et non substituées ; des halogènes ; et des groupes thiophényle ;
et
dans lesquelles :
dans la formule (i), les groupes méthyle peuvent être remplacés par C₁ à C₄ alkyle ou aryle ou hétéroaryle monocyclique ou polycyclique, lequel peut être en outre substitué par exemple par alkyle, aryle ou arylamino ;
(c) le matériau de transport de trous comprend un composé de la formule : 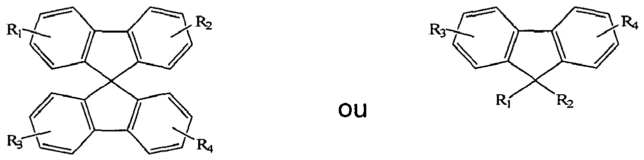 dans lesquelles :
les groupes R₁ à R₄, lorsqu'ils apparaissent dans l'une ou l'autre des formules mentionnées ci avant, peuvent être les mêmes ou différents et sont choisis parmi hydrogène ; des groupes aliphatiques substitués et non substitués ; des structures de cycle aromatiques, hétérocycliques et polycycliques substituées et non substituées ; des halogènes ; et des groupes thiophényle ;
(d) la couche de transport de trous comprend α-NPB

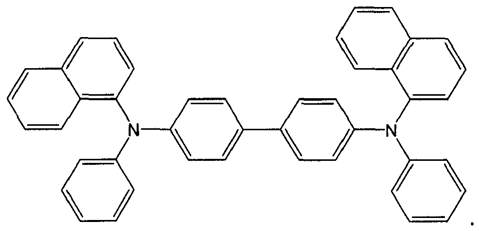

11. Dispositif selon une ou plusieurs des revendications 8 à 10, **caractérisé en ce que** la couche électroluminescente comporte une ou plusieurs des caractéristiques qui suivent :
(a) elle comprend un métal ou un complexe métalloïde ;
(b) elle comprend du quinolate de zirconium en tant que matériau hôte dopé avec un dopant ;
(c) elle comprend du quinolate de zirconium monoclinique ;
(d) elle comprend du quinolate d'aluminium en tant que matériau hôte dopé avec un dopant ;
(e) elle comprend un complexe d'iridium, de ruthénium, d'osmium, de rhodium, de palladium ou de platine, un complexe de bore ou un complexe des terres rares ;
(f) elle comprend un amine tertiaire aromatique en tant que matériau hôte dopé avec un dopant;
(g) elle comprend un matériau hôte choisi parmi les carbazols, les cétones, les phosphinoxydes, les sulfoxydes, les hôtes bipolaires, et des oligoarylènes choisis parmi les anthracènes, les dinaphthylanthracènes, les benzanthracène anthracènes, les tétraphénylspirobifluorènes ;
(h) elle comprend un polymère ou copolymère conjugué émetteur de lumière ou un dendrimère ;
(i) elle comprend du quinolate de zirconium monoclinique dopé avec un dopant ;
(j) le dopant est choisi parmi les émetteurs phosphorescents, diphénylacridine, les coumarines, pérylène, les quinolates, les porphyrines, les porphines, les pyrazalones et leurs dérivés, les arylamines, de façon préférable les indénofluorène monoamines et diamines, les benzofluorène monoamines et diamines et les dibenzoindénofluorène monoamines et diamines ;
(k) il y a un matériau fluorescent jusqu'à 10 moles pourcent, sur la base des moles de complexe organométallique ;
(l) il y a un matériau fluorescent jusqu'à 1 mole pourcent, sur la base des moles de complexe organométallique ;
(m) il y a un matériau fluorescent à moins de 10⁻³ mole pourcent, sur la base des moles de complexe organométallique.

12. Dispositif selon une ou plusieurs des revendications 8 à 11, **caractérisé en ce que** la couche de transport d'électrons comprend du quinolate de zirconium monoclinique ou une composition comprenant du quinolate de zirconium monoclinique et au moins un autre matériau de transport d'électrons, de façon préférable choisi parmi les benzimidazoles et les quinolates de Li, Al, Ga, Mg, Zn et Be, de façon particulièrement préférable du quinolate de lithium.

13. Dispositif selon une ou plusieurs des revendications 8 à 12, comportant une couche d'injection d'électrons sur la base des quinolates métalliques, de façon préférable les quinolates de Li, Al, Ga, Mg, Zn et Be ou un composé de lithium inorganique ou un complexe de lithium.

14. Dispositif selon l'une quelconque des revendications 8 à 13, lequel est un affichage à écran plat.

15. Dispositif selon la revendication 14, lequel est un affichage à matrice passive.

16. Dispositif selon la revendication 14, lequel est un affichage à matrice active.

17. Elément imageur pour la création d'une image latente électrostatique contenant du quinolate de zirconium monoclinique.

18. Lampe contenant un matériau électroluminescent et du quinolate de zirconium monoclinique en tant qu'hôte ou en tant que matériau de transport d'électrons.
